(19) Europäisches Patentamt
European Patent Office
Office européen des brevets

(11) **EP 3 349 027 B1**

(12) **EUROPÄISCHE PATENTSCHRIFT**

(45) Veröffentlichungstag und Bekanntmachung des Hinweises auf die Patenterteilung:
**16.10.2019  Patentblatt 2019/42**

(51) Int Cl.:
**G01R 33/00** *(2006.01)*   **G01R 33/07** *(2006.01)*

(21) Anmeldenummer: **17206737.3**

(22) Anmeldetag: **12.12.2017**

(54) **VERFAHREN ZUR OFFSET-KOMPENSATION EINES SENSORSIGNALS EINES HALL-SENSORS UND SENSORANORDNUNG**

METHOD FOR OFFSET COMPENSATION OF A SENSOR SIGNAL OF A HALL SENSOR AND SENSOR ARRANGEMENT

PROCÉDÉ DE COMPENSATION OFFSET D'UN SIGNAL DE CAPTEUR D'UN CAPTEUR À EFFET HALL ET DISPOSITIF CAPTEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **16.12.2016   DE 102016225305**

(43) Veröffentlichungstag der Anmeldung:
**18.07.2018   Patentblatt 2018/29**

(73) Patentinhaber: **Fraunhofer-Gesellschaft zur Förderung der angewandten Forschung e.V. 80686 München (DE)**

(72) Erfinder:
• **Stahl-Offergeld, Markus 91058 Erlangen (DE)**
• **Sand, Markus 92723 Tännesberg (DE)**
• **Hohe, Hans-Peter 91332 Heiligenstadt (DE)**

(74) Vertreter: **Hersina, Günter et al Schoppe, Zimmermann, Stöckeler Zinkler, Schenk & Partner mbB Patentanwälte Radlkoferstrasse 2 81373 München (DE)**

(56) Entgegenhaltungen:
**EP-A1- 1 498 697        DE-A1-102007 044 471
DE-A1-102011 102 483     US-A1- 2014 225 597
US-A1- 2014 266 176      US-A1- 2015 338 473**

• **TIMO KAUFMANN ET AL: "Piezoresistive Response of Vertical Hall Devices", IEEE SENSORS JOURNAL, IEEE SERVICE CENTER, NEW YORK, NY, US, Bd. 11, Nr. 11, 1. November 2011 (2011-11-01), Seiten 2628-2635, XP011363316, ISSN: 1530-437X, DOI: 10.1109/JSEN.2011.2153194**

**Beschreibung**

Ausführungsbeispiele beziehen sich auf eine Vorrichtung und ein Verfahren zur Offset-Kompensation eines Sensorsignals eines Hall-Sensors und auf eine Sensoranordnung mit einem Hall-Sensor und einer Verarbeitungseinrichtung zur Ausführung des Verfahrens. Insbesondere beziehen sich Ausführungsbeispiele auf ein Konzepts zur Offset-Kompensation eines Sensorausgangssignals eines Hall-Sensors mittels Modulation bzw. Variation des Versorgungssignals, wobei sich durch eine Modulation der Versorgungsspannung des Hall-Sensors der Offsetanteil im Sensorausgangssignal beispielsweise auch mit einem anliegenden externen Magnetfeld bestimmen lässt, falls das externe Magnetfeld während der Bestimmung des Offsetanteils innerhalb eines Toleranzbereichs konstant ist.

Wird ein Hall-Sensor von einem elektrischen Strom durchflossen und liegt ein Magnetfeld mit einer senkrecht zu dem Strom verlaufenden Magnetfeldkomponente an, liefert der Hall-Sensor ein Ausgangssignal in Form einer Ausgangsspannung (Hall-Spannung), die proportional zum Produkt aus magnetischer Flussdichte und elektrischer Stromstärke ist. Hall-Sensoren bzw. Hall-Effektelemente besitzen i.A. einen hohen, stark temperaturabhängigen Offsetanteil in dem ausgegebenen Sensorsignal.

Der Offsetanteil kann mit Hilfe unterschiedlicher, auch kombinierbarer Vorgehensweisen, wie dem Spinning-Current-Prinzip (SC-Verfahren), der orthogonalen Paarbildung oder der Zwangssymmetrierung verringert werden.

Beim sogenannten "Spinning-Current-Prinzip" werden zur Unterdrückung des durch Geometriefehler, piezoresistive Effekte, inhomogene Temperaturen etc. entstehende Offsetanteile (Offset-Spannung) im Sensorausgangssignal Hall-Sensoren mit mehreren Anschlüssen symmetrisch aufgebaut, z. B. bei lateralen Hall-Sensoren rotationssymmetrisch. Die Erfassungskontakte (Hall-Kontakte) sind damit in ihrer Form identisch realisiert wie Versorgungskontakte (Stromkontakte). Zwei dieser Anschlüsse dienen dann als Versorgungskontakte, während zwei als Hallsignalerfassungskontakte dienen. Die Funktion der Anschlüsse wird "reihum" (in aufeinanderfolgenden Phasen in unterschiedlichen Stromrichtungen aufeinanderfolgend) vertauscht. Durch eine entsprechende Auswertung der Messergebnisse kann der resultierende Offsetanteil im Hallsensorausgangssignal deutlich reduziert werden. Dabei ist es möglich, diesen Spinning-Current-Betrieb sowohl räumlich als auch zeitlich zu realisieren. "Räumlich" bedeutet, dass mehrere Hall-Sensoren in enger räumlicher Nachbarschaft realisiert und gleichzeitig mit unterschiedlichen Stromrichtungen betrieben werden. "Zeitlich" bedeutet, dass ein Hall-Sensor zeitlich hintereinander mit unterschiedlichen Stromrichtungen betrieben wird. Der finale Messwert ist dabei jeweils beispielsweise der Mittelwert aus den Einzelmesswerten der unterschiedlichen Betriebsstromrichtungen in den unterschiedlichen Spinning-Current-Betriebsphasen. Ferner können beide Vorgehensweisen der zeitlichen und räumlichen Realisierung des Spinning-Current-Betriebs kombiniert werden.

Auch vertikale Hall-Sensoren können mit dem Spinning-Current-Prinzip betrieben werden auch ohne eine rotationssymmetrische Ausgestaltung dieser Hall-Sensoren. Eine resultierende Rotationssymmetrie kann beispielsweise durch eine geeignete Geometrie eines einzelnen Hall-Sensors erzeugt werden, oder es können mehrere vertikale Hall-Sensoren (Halleffekt-Sensorelemente) "zwangssymmetriert" werden.

Eine weitere Möglichkeit, den Offsetanteil im Sensorausgangssignal von lateralen Hall-Sensoren zu reduzieren, ist die "orthogonale Paarbildung". Hier werden mehrere laterale Hall-Sensoren, z. B. Vielfache von zwei parallel geschaltet, jedoch ähnlich dem Spinning-Current-Prinzip mit unterschiedlicher Stromrichtung. Die orthogonale Paarbildung entspricht somit dem oben beschriebenen "räumlichen" Spinning-Current-Betrieb von entsprechend verschalteten lateralen Hall-Sensoren.

Bei vertikalen Hall-Sensoren kann beispielsweise eine sogenannte "Zwangssymmetrierung" zur Offset-Kompensation angewendet werden. Vertikale Hall-Sensoren besitzen aufgrund der Raumladungszone und der Geometrie der Elemente in den unterschiedlichen Spinning-Current-Phasen unterschiedliche Innenwiderstände, die zum Teil zu großen Einzelphasen-Offsets führen, so dass vertikale Hall-Sensoren nur bedingt nach dem Spinning-Current-Prinzip betrieben werden können. Zur Umsetzung des Spinning-Current-Prinzips bei vertikalen Hall-Sensoren kann dann beispielsweise die sogenannte "Zwangssymmetrierung" vorgenommen werden, wobei vertikale Hall-Sensoren, die jeweils um einen Kontakt verschoben sind, parallel geschaltet werden, obwohl die Elemente elektrisch nicht symmetrisch sind. Es fließen somit zwischen den Hall-Sensoren Ausgleichsströme, so dass sich nach außen hin die aus mehreren Hall-Sensoren bestehende vertikale Hall-Sensoranordnung rotationssymmetrisch zeigt und somit auch gut mit dem Spinning-Current-Prinzip betrieben werden kann.

Obwohl der Offsetanteil mit Hilfe des Spinning-Current-Prinzip, der orthogonalen Paarbildung oder der Zwangssymmetrierung verringert werden können, bleibt in dem Sensorausgangssignal jedoch häufig weiterhin ein temperaturabhängiger Rest-Offsetanteil bestehen bleibt. Für viele Anwendungen von Hall-Sensoren muss dieser Rest-Offsetanteil noch weiter verringert werden, weshalb diese Hall-Sensoren in einem Serientest im Betriebstemperaturbereich einzeln vermessen und kalibriert werden müssen. Dieser Kalibriervorgang gestaltet sich im Allgemeinen sehr (Zeit-) aufwendig, da der zu kompensierende temperaturabhängige Offsetanteil der Hall-Sensoren in einem Serientest bei verschiedenen Temperaturen gemessen und dann im Hall-Sensor zur Offset-Korrektur hinterlegt werden muss. Diese Offset-Kompensation gestaltet sich sehr zeitaufwändig und verursacht damit relativ hohe Herstellungskosten für die entsprechenden Hall-Sensoren.

Die US 2014/266176 A1 bezieht sich auf einen Magnetfeldsensor mit einem Komparatordetektor, bei dem ein gemessener Schwellwert vor dem Abschalten gespeichert wird und auf das Einschalten hin zur Verwendung durch den Komparatordetektor wieder abgerufen wird.

Die US 2014/0225597 A1 bezieht sich auf einen Magnetfeldsensor und zugehörige Techniken, die ein Winkelkorrekturmodul bereitstellen. Der Magnetfeldsensor kann eine Vielzahl von unterschiedlichen Strom-Spinning-Phasen-Sequenzen verwenden und/oder kann einen Winkelfehlerwert bereitstellen, um Fehler des Magnetfeldsensors zu korrigieren.

Die DE 10 2011 102 483 A1 bezieht sich auf ein Verfahren zum Betreiben einer Hallsensoranordnung und auf eine Hallsensoranordnung. Gemäß dem Verfahren zum Betreiben der Hallsensoranordnung werden mindestens zwei betragsmäßig unterschiedliche Werte eines Eingangssignals eines Hallsensors der Hallsensoranordnung eingestellt und die dazugehörigen Werte eines Ausgangssignals des Hallsensors bestimmt. Weiter wird ein Rest-Offsetwert des Ausgangssignals in Abhängigkeit von den Werten des Ausgangssignals, die bei den mindestens zwei Werten des Eingangssignals bestimmt wurden, bestimmt.

Ausgehend von dem vorliegenden Stand der Technik besteht die zugrunde liegende Aufgabe darin, ein verbessertes Konzept zur Offset-Kompensation eines Sensorausgangssignals eines Hall-Sensors zu schaffen.

Diese Aufgabe wird durch die unabhängigen Patentansprüche gelöst.

Weiterbildungen des vorliegenden Konzepts sind in den zugeordneten Unteransprüchen definiert.

Der Kerngedanke des vorliegenden Konzepts besteht nun darin, dass sich durch eine Modulation bzw. Variation des Versorgungssignals eines Hall-Sensors in dem daraus resultierenden Sensorausgangssignal eine Trennung des Nutzsignalanteils vom Offsetanteil während des Betriebs des Hall-Sensors auch ohne vorherige Kalibration bzw. ohne vorherigen Serientest bewerkstelligen lässt. Der aus der Modulation bzw. Variation des Versorgungssignals resultierende Verlauf des Sensorausgangssignals kann nun hinsichtlich der Komponenten, die auf den Offsetanteil und den Nutzsignalanteil zurückzuführen sind, ausgewertet bzw. zerlegt werden. Dabei lässt sich der Offsetanteil im Sensorausgangssignal ohne einem (bzw. mit einem vernachlässigbar kleinem) anliegenden, externen Magnetfeld oder auch mit einem anliegenden, externen Magnetfeld bestimmen, falls beispielsweise das externe Magnetfeld während der Bestimmung des Offsetanteils innerhalb eines Toleranzbereichs konstant ist.

Da in der Realität das externe Magnetfeld häufig nicht exakt als konstant angenommen werden kann bzw. das vorliegende Konzept noch ausreichend gute Kompensationsergebnisse liefert, wenn das externe Magnetfeld (d.h. die Magnetfeldstärke bzw. Flussdichte) innerhalb eines vorgegeben Bereichs bleibt oder kein oder nur ein vernachlässigbar kleines externes Magnetfeld anliegt, wird ein sogenannter "Toleranzbereich" für die "geforderte Konstanz" des externen Magnetfelds eingeführt bzw. vorgesehen. Der Toleranzbereich gibt also den Bereich an, innerhalb dessen sich das externe Magnetfeld während der Bestimmung des Offsetanteils bzw. Rest-Offsetanteils ändern darf. Der Toleranzbereich kann beispielsweise angeben, dass sich das externe Magnetfeld während der Bestimmung des Offsetanteils bzw. Rest-Offsetanteils weniger als 50%, 30%, 20%, 10%, 5%, 1% oder 0,1% ändert oder kein oder nur ein vernachlässigbar kleines externes Magnetfeld vorhanden ist. Je niedriger der Toleranzbereich angenommen wird und eingehalten werden kann, umso genauer kann die Offsetkompensation durchgeführt werden.

Falls eine mögliche oder typische Änderungsrate des externen Magnetfelds bekannt ist, kann ein Zeitintervall Δt1 für den Kompensationsvorgang so gewählt werden, dass die Offset-Messvorgänge zeitlich so (kurz) aufeinanderfolgend ausgeführt werden, dass während des Zeitintervalls Δt1 das auf dem Hall-Sensor einwirkende Messmagnetfeld innerhalb des (vorgegebenen) Toleranzbereichs konstant ist oder kein oder nur ein vernachlässigbar kleines externes Magnetfeld vorhanden ist.

Der Offsetanteil im Ausgangssignal eines Hall-Sensors ist stark von dem Versorgungssignal, z. B. der Versorgungsspannung oder dem Versorgungsstrom, abhängig, wobei für einen niedrigen Versorgungssignalwert der Offsetanteil in dem Sensorausgangssignal als vernachlässigbar (d.h. ≤ 20%, 10%, 5%, 1% oder 0,1% des Nutzsignalanteils) angesehen werden kann, während der Offsetanteil in dem Sensorausgangssignal mit steigenden Versorgungssignalwerten "nicht-linear" ansteigt. Demgegenüber ist die Empfindlichkeit eines Hall-Sensors direkt proportional zum angelegten Versorgungssignal. Unter der Annahme, dass während der Ermittlung des Offsetanteils in dem Sensorausgangssignal, das auf den Hall-Sensor einwirkende Messmagnetfeld innerhalb eines Toleranzbereichs konstant ist und beispielsweise auch keine "wesentliche" Änderung der momentanen Temperatur an dem Hall-Sensor stattfindet, kann eine Trennung zwischen dem Nutzsignalanteil und dem Offsetanteil in dem Sensorausgangssignal im Betrieb erreicht werden, indem eine "Modulation" (d. h. eine Einstellung unterschiedlicher Werte) des Versorgungssignals vorgenommen wird. Der Offsetanteil in dem Sensorausgangssignal kann dann nahezu eliminiert bzw. zumindest stark reduziert werden, da der "quasi-Offset-freie" Messwert für das Sensorausgangssignal bei einem sehr niedrigen Versorgungssignalwert ermittelt werden kann, während anschließend im Normalbetrieb bei einem hohen Versorgungssignalwert der Offsetanteil bestimmt und aus dem Sensorausgangssignal entfernt werden kann.

Somit lässt sich die hohe Empfindlichkeit eines Hall-Sensors bei hohen Versorgungssignalwerten mit dem niedrigen Offsetanteil in dem Sensorausgangssignal bei einem niedrigen Versorgungssignalwert kombinieren, d. h. der Offsetanteil bei dem hohen Versorgungssignalwert lässt sich basierend auf der bekannten (hohen) Empfindlichkeit des Hall-Sensors und auf dem (quasi-Offset-freien) Messwert bei dem niedrigen Versorgungssignalwert während des Betriebs des Hall-Sensors bestimmen.

Zur Umsetzung des erfindungsgemäßen Konzepts zur Offset-Kompensation eines Sensorausgangssignals eines Hall-Sensors können nun beispielsweise unterschiedliche Vorgehensweisen mit einer Modulation bzw. Variation des Versorgungssignals gewählt werden.

Gemäß einem Ausführungsbeispiel besteht eine mögliche Vorgehensweise zur Umsetzung des erfindungsgemäßen Konzepts darin, durch eine "Modulation bzw. Variation" des Versorgungssignals und eine entsprechende Messung des Sensorausgangssignals bei verschiedenen (modulierten) Versorgungssignalwerten eine typische Funktion für den Ausgangssignalverlauf über den Versorgungssignalverlauf zu erhalten, wobei diese typische Funktion beispielsweise den Verlauf des nicht-linearen Offsetanteils über dem Versorgungssignal nachbildet. Wird diese "typische Funktion" um einen linearen Anteil, der dem vorliegenden zu messenden externen Magnetfeld B entspricht, ergänzt, kann diese typische Funktion verwendet werden, um sowohl den Offsetanteil als auch den Nutzsignalanteil in dem Sensorausgangssignal als Funktion über dem Versorgungssignal nachzubilden. Hierzu wird das Versorgungssignal, z. B. die Sensorspannung, moduliert bzw. variiert, und bei einer Vielzahl von Messpunkten, d. h. bei zumindest drei oder auch mehr Messpunkten, der zugehörige Sensorsignalwert (Sensorausgangssignalwert) ermittelt. Basierend auf diesen "Messpunkten" wird nun die typische Funktion, z. B. mittels eines Mess-Kits, "angefittet" (ermittelt). Diese typische Funktion wird beispielsweise auch als eine "Fitting-Funktion" bezeichnet.

So weist die Fitting-Funktion $F(S_{DD})$ für das (z. B. vorkompensierte) Sensorausgangssignal über dem Versorgungssignal $S_{DD}$ basierend auf den ermittelten N-Sensorsignalwerten $S_N$ eine Kombination aus einem konstanten Anteil, einem linearen Anteil und einem nicht-linearen Anteil auf, wobei der nicht-lineare Anteil der Fitting-Funktion auf einem Rest-Offsetanteil in dem (vorkompensierten) Sensorsignal basiert.

Wenn nun das Sensorsignal proportional zu einer erfassten Hall-Spannung des Hall-Sensors ist, basiert der "lineare" Anteil der Fitting-Funktion auf dem (konstant anliegenden) Messmagnetfeld. Entsprechend dem erfindungsgemäßen Konzept kann also beispielsweise direkt die gemessene Hall-Spannung (als Sensorausgangssignal) verwendet werden, wobei durch den proportionalen Zusammenhang von Versorgungssignal und Empfindlichkeit des Hall-Sensors der lineare Anteil der Fitting-Funktion (gefitteten Funktion) den annähernd Offset-freien Nutzsignalanteil (Messwert) angibt.

Wenn dagegen das vorkompensierte Sensorausgangssignal proportional zu dem berechneten, externen Magnetfeld ist, das basierend auf der erfassten Hall-Spannung und der Empfindlichkeit des Hall-Sensors ermittelt wird, basiert der "konstante" Anteil der Fitting-Funktion auf dem (konstant anliegenden) Messmagnetfeld. Die beschriebene Vorgehensweise lässt sich also auch anwenden, wenn das Sensorausgangssignal, d. h. die gemessene Hall-Spannung, bereits mittels der Empfindlichkeit des Hall-Sensors, in den Wert des anliegenden Messmagnetfelds umgerechnet wurde. In diesem Fall ist eine andere typische Funktion zu verwenden, wobei der "konstante Anteil" der gefitteten Funktion als resultierendes (nahezu Offset-freies) Messsignal zu verwenden ist, da im mT-Bereich bei Hall-Sensoren das Ausgangssignal über dem Versorgungssignal i.W. konstant ist.

Abhängig von der Art bzw. Aufbereitung des (vorkompensierten) Sensorausgangssignals, das beispielsweise proportional zu der erfassten Hall-Spannung des Hall-Sensors oder (alternativ) proportional zu dem einwirkenden Messmagnetfeld ist, kann somit der annähernd Offset-freie Messwert, d. h. der Nutzsignalanteil des Sensorausgangssignals, erhalten werden. Wird nun der Hall-Sensor wieder mit dem "vollen" (hohen) Versorgungssignal betrieben, so lässt sich der Offsetanteil bei diesem hohen Versorgungssignal bestimmen. Mit diesem ermittelten Offsetanteil können nun die weiteren Messwerte, d. h. das Sensorausgangssignal, korrigiert werden.

Die Bestimmung einer Fitting-Funktion ist mit einer gewissen erforderlichen Rechenleistung verbunden. Betrachtet man eine mögliche typische Funktion (Fitting-Funktion) z.B. mit $f(x) = a + bx + e^{dx}$, oder $f(x) = a + bx + dx^n$ ... (Taylor-Reihe), mit $x = S_{DD}$, so geht für kleine Versorgungssignale der nicht-lineare Term, d.h. der Term $e^{dx}$ oder die Terme höherer Ordnung bei einer Taylor-Reihe, nahezu gegen null. Ausgehend von der gemessenen Hall-Spannung des Hall-Sensors als Sensorausgangssignal ist der konstante Anteil der typischen Funktion im Allgemeinen sehr gering, da beispielsweise der lineare Anteil des Offsets beispielsweise bereits durch die Anwendung eines Spinning-Current-Prinzips vorkompensiert bzw. verringert wurde.

Man kann also die hohe Empfindlichkeit bei dem hohen Versorgungssignal mit dem niedrigen Offsetanteil bei dem niedrigen Versorgungssignal kombinieren, um bei dem hohen Versorgungssignal den Offset-kompensierten Nutzsignalanteil des Sensorausgangssignals zu bestimmen.

Die Bestimmung einer Fitting-Funktion ist mit einer gewissen erforderlichen Rechenleistung verbunden, die mit der nachfolgenden beschriebenen weiteren Vorgehensweise bei weiterhin sehr guten Kompensationsergebnissen deutlich reduziert werden kann.

Gemäß einem Ausführungsbeispiel für eine weitere mögliche Vorgehensweise zur Umsetzung des erfindungsgemäßen Konzepts kann mit einer (z. B. einzigen) Messung bei einem niedrigen Versorgungssignalwert unter Kenntnis der Empfindlichkeit des Hall-Sensors das (momentan anliegende) externe Messmagnetfeld mit einem deutlich reduzierten Offsetanteil gemessen bzw. erfasst werden. Ist der (niedrige) Versorgungssignalwert ausreichend niedrig gewählt, kann der Rest-Offsetanteil in dem Sensorausgangssignal als vernachlässigbar niedrig angesehen werden.

In der praktischen Anwendung für diese Vorgehensweise bedeutet dies, dass das externe Messmagnetfeld mit einem niedrigen Versorgungssignalwert an dem Hall-Sensor gemessen wird. Der niedrige Versorgungssignalwert ist z.B. kleiner oder gleich ($\leq$) 50%, 30%, 20% oder 10% als der höhere Versorgungssignalwert zu wählen. Hierdurch wird ein Messwert (Sensorausgangssignal bzw. Sensorausgangssignalwert) mit einem sehr niedrigen (vernachlässigbaren) Offsetanteil ermittelt, der z. B. zu "0" angenommen werden kann. Anschließend wird der Versorgungssignalwert, z. B. die Versorgungsspannung oder der Versorgungsstrom, wieder erhöht, woraufhin eine erneute Messung des Sensorausgangssignals bei dem höheren Versorgungssignalwert durchgeführt wird. Jetzt enthält das Messsignal bzw. der Messwert das eigentliche Magnetfeld (als Nutzsignalanteil) und den relativen großen Offsetanteil.

Unter der Annahme, dass das externe Magnetfeld während dieser Zeit zwischen den beiden Messvorgängen im Wesentlichen (d. h. innerhalb eines vorgegebenen Toleranzbereichs) konstant geblieben ist, kann dann der verbleibende Offsetanteil bei dem hohen Versorgungssignalwert ermittelt bzw. bestimmt werden. Die weiteren Messwerte bzw. Sensorsignalwerte bei diesem hohen Versorgungssignalwert, können jetzt um den Offsetanteil korrigiert werden, d. h. der Offsetanteil kann von dem jeweiligen Messwert abgezogen werden, um den verbleibenden Nutzsignalanteil in dem Sensorausgangssignal zu erhalten.

Somit kann also die hohe Empfindlichkeit eines Hall-Sensors bei einem hohen Versorgungssignalwert mit dem niedrigen Offsetanteil bei einem niedrigen Versorgungssignalwert kombiniert werden, um das Offset-reduzierte bzw. Offset-kompensierte Sensorausgangssignal bei dem hohen Versorgungssignalwert zu erhalten.

Es ist also möglich, mit einer (einzigen) Messung bei einem niedrigen Versorgungssignal das anliegende, externe Messmagnetfeld mit einem deutlich reduzierten Offset in dem Sensorausgangssignal zu messen. Bei dem niedrigen Versorgungssignal bleiben lediglich der konstante Anteil und der exponentielle Anteil als Rest-Offsetanteil zurück, die aber vernachlässigbar klein sind. In der praktischen Anwendung bedeutet dies, dass das externe Messmagnetfeld mit einem (ausreichend) niedrigen Versorgungssignal gemessen wird. Hierdurch erhält man einen Messwert (Sensorausgangssignal) mit einem sehr niedrigen Offsetanteil, der zu null angenommen werden kann. Anschließend wird das Versorgungssignal wieder erhöht und eine erneute Messung des Sensorausgangssignals vorgenommen. Jetzt enthält das Messsignal, d. h. das Sensorausgangssignal, bei dem hohen Versorgungssignal das eigentliche Messmagnetfeld und den relativ großen Offsetanteil. Unter der Annahme, dass das anliegende externe Messmagnetfeld während dieser Messzeitpunkte (innerhalb eines Toleranzbereichs) konstant geblieben ist, kann so der Offsetanteil bei dem hohen Versorgungssignal als Differenz zwischen dem Messsignalwert (bei dem hohen Versorgungssignal) und dem Messsignalwert bei dem niedrigen Versorgungssignal ermittelt werden. Die weiteren Messwerte bei dem hohen Versorgungssignal können nun um den ermittelten Offsetanteil korrigiert werden.

Diese Offset-Kompensation des Ausgangssignals eines Hall-Sensors kann in Betrieb des Hall-Sensors ohne eine vorherige Kalibration oder einen vorherigen Serientest dieses Hall-Sensors durchgeführt werden.

Das vorliegende Konzept kann somit beispielsweise bei Hall-Sensoren zur Kompensation des vorhandenen temperaturabhängigen Offsetanteils im Sensorausgangssignal eingesetzt werden, wobei auch bereits auf das Sensorsignal angewandte Prinzipien zur OffsetKompensation, wie dem Spinning-Curling-Prinzip (SC-Prinzip), der orthogonalen Paarbildung und der Zwangssymmetrierung, bei denen im Allgemeinen aber ein temperaturabhängiger Rest-Offsetanteil bestehen bleibt, weiter unterstützt werden kann.

Das vorliegende Konzept zeichnet sich nun insbesondere dadurch aus, dass der Offsetanteil eines Sensorausgangssignals eines Hall-Sensors (Hall-Sensors) im laufenden Betrieb zumindest näherungsweise bestimmt werden kann, ohne dass ein aufwendiger Serientest bzw. eine Kalibrierung bei zum Teil verschiedenen Temperaturen zur Offset-Kompensation vorab erforderlich ist.

Bei einer Vorkompensation mittels eines der oben genannten Prinzipien, wie z. B. Spinning-Curling, orthogonaler Paarbildung und/oder Zwangssymmetrierung, können bereits konstante und lineare Offsetanteile in dem Hallsensorausgangssignal bzw. in der Hall-Spannung nahezu vollständig entfernt werden. Bei einer Auftragung des gemessenen Hall-Ausgangssignals (Hall-Spannung) über dem Versorgungssignal, z. B. der Versorgungsspannung oder dem Versorgungsstrom eines Hall-Elements können damit die "linearen Anteile" dieses Verlaufs nur noch von dem magnetischen Signal, d. h. dem anliegenden externen Magnetfeld, verursacht werden. Alle anderen Anteile, konstante Anteile, nichtlineare Anteile, quadratische Anteile und/oder Anteile höherer Ordnungen, können dann von dem Ausganssignalverlauf separiert und als Offsetanteil interpretiert werden.

Damit ist "rechnerisch" eine Offset-Korrektur des Sensorausgangssignals während des Betriebs ohne vorherige Kalibration oder vorherigen Serientest möglich. Das erfindungsgemäße Konzept beruht somit auf der Tatsache, dass der Offsetanteil eines (z. B. vorkompensierten) Sensorausgangssignals eines Hall-Sensors stark von der Versorgungsspannung abhängig ist. Die Empfindlichkeit eines Hall-Sensors ist demgegenüber direkt proportional zur Versorgungsspannung. Die Ausnutzung dieser Zusammenhänge ermöglicht somit das vorliegende Prinzip der Trennung von Nutzsignalanteil und Offsetanteil im Sensorausgangssignal zur Offset-Kompensation im Betrieb eines Hall-Sensors.

Mit dem vorliegenden Konzept zur Offset-Kompensation ist es nicht nur möglich, den Offsetanteil während des Betriebs und ohne vorherige Kalibration bzw. ohne vorherigen Serientest des Hall-Sensors durchzuführen, sondern darüber hinaus ist es möglich, Fehler im gesamten System bzw. der gesamten Schaltungsanordnung zu erkennen, da der Offsetanteil der Hall-Sensoren im Betrieb weiterhin bekannt ist und somit Rückschlüsse auf Systemfehler möglich sind. Dies war bisher nicht möglich, da man bisher nicht zwischen einer Sensor-Offsetdrift und einer Verstärker-Offsetdrift innerhalb der Schaltungsanordnung unterscheiden konnte und somit bisher keine Rückschlüsse diesbezüglich möglich waren.

Bevorzugte Ausführungsbeispiele der vorliegenden Erfindung werden nachfolgend unter Bezugnahme auf die beiliegenden Zeichnungen näher erläutert. Hinsichtlich der dargestellten Figuren wird darauf hingewiesen, dass die dargestellten Funktionsblöcke sowohl als Elemente oder Merkmale einer Sensoranordnung als auch entsprechende Verfahrensschritte/Prozessabläufe des vorliegenden Konzepts zur Offset-Kompensation zu verstehen sind. Es zeigt:

Fig. 1    ein Flussdiagramm eines Verfahrens zur Offset-Kompensation gemäß einem Ausführungsbeispiel;

Fig. 2    ein Flussdiagramm eines Verfahrens zur Offset-Kompensation gemäß einem weiteren Ausführungsbeispiel;

Fig. 3    eine graphische Darstellung eines typischen Verlaufs bzw. Zusammenhangs eines Offsetanteils eines (z. B. bereits Spinning-Currentkompensierten) Hallsensorausgangssignals eines Hall-Sensors über dem Versorgungssignal;

Fig. 4    eine graphische Darstellung eines typischen Verlaufs der Empfindlichkeit eines Hall-Sensors über dem Versorgungssignal;

Fig. 5    eine graphische Darstellung von typischen Messwerten eines Sensorausgangssignals und eines typischen Verlaufs einer gefitteten Funktion (Fitting-Funktion) eines Sensorausgangssignals eines Hall-Sensors basierend auf den Messwerten über dem Versorgungssignal gemäß einem Ausführungsbeispiel;

Fig. 6    eine graphische Darstellung der Komponenten in Form eines konstanten Anteils, eines linearen Anteils und eines nicht-lineares Anteils der FittingFunktion von Fig. 5 gemäß einem Ausführungsbeispiel;

Fig. 7    eine graphische Darstellung von Messwerten eines externen Magnetfelds und des linearen Anteils der typischen Fitting-Funktion über dem Versorgungssignal gemäß einem Ausführungsbeispiel;

Fig. 8    eine graphische Darstellung der Messwerte des Sensorausgangssignals bei einem konstanten, externen Magnetfeld, des linearen Anteils der typischen Fitting-Funktion und des über die Empfindlichkeit des Hall-Sensors berechneten konstanten, externen Magnetfelds über dem Versorgungssignal gemäß einem Ausführungsbeispiel; und

Fig. 9    ein beispielhaftes Blockdiagramm einer Sensoranordnung mit einem HallSensor und einer Verarbeitungseinrichtung gemäß einem Ausführungsbeispiel.

Bevor nachfolgend Ausführungsbeispiele des vorliegenden Konzepts im Detail anhand der Figuren näher erläutert werden, wird darauf hingewiesen, dass identische, funktionsgleiche oder gleichwirkende Elemente, Objekte, Funktionsblöcke und/oder Verfahrensschritte in den unterschiedlichen Figuren mit den gleichen Bezugszeichen versehen sind, so dass die in den unterschiedlichen Ausführungsbeispielen dargestellte Beschreibung dieser Elemente, Objekte, Funktionsblöcke und/oder Verfahrensschritte untereinander austauschbar ist bzw. aufeinander angewendet werden kann.

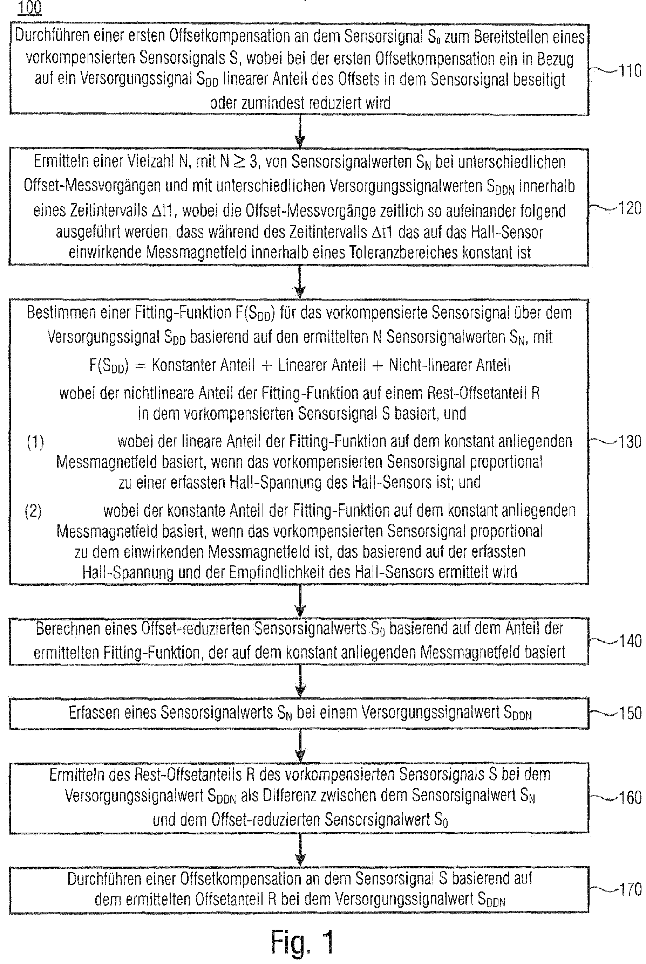

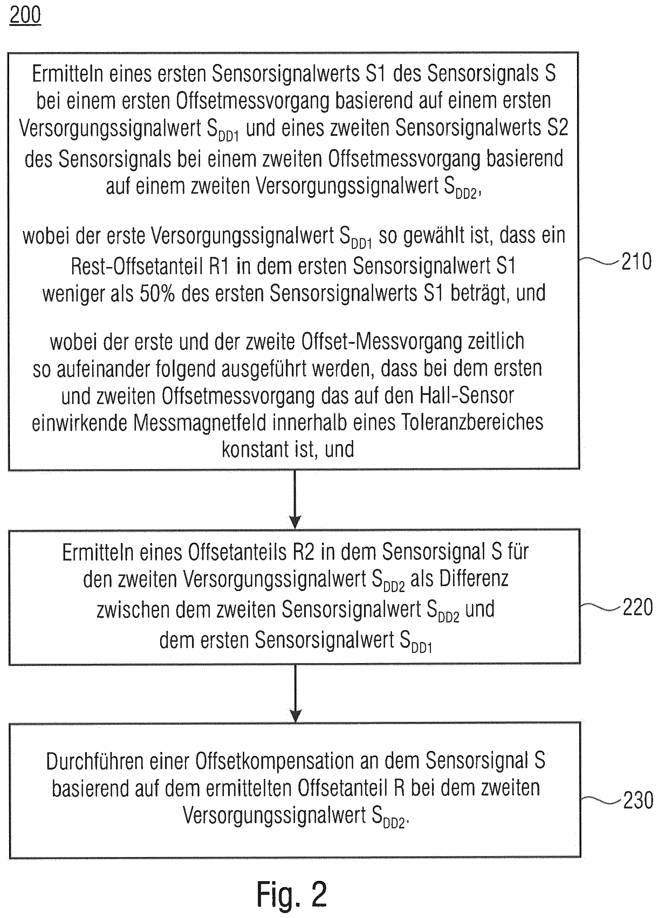

Fig. 1 und 2 zeigen Flussdiagramme des erfindungsgemäßen Konzepts zur Offset-Kompensation eines Sensorausgangssignals eines Hall-Sensors mittels Modulation bzw. Variation des Versorgungssignals, z. B. der Versorgungsspannung bzw. des Versorgungsstroms. Ein Hall-Sensor kann beispielsweise ein Halleffekt-Sensorelement oder eine Mehrzahl von (z.B. verschalteten) Halleffekt-Sensorelementen aufweisen. Das Sensorsignal kann ein Sensorausgangssignal eines einzelnen Halleffekt-Sensorelements oder eine Kombination der Sensorausgangssignale von einem Teil der Mehrzahl von Halleffekt-Sensorelementen oder von allen der Mehrzahl von Halleffekt-Sensorelementen sein. Das Sensorsignal kann dabei auch auf dem Sensorausgangssignal eines einzelnen Halleffekt-Sensorelements oder auf einer Kombination der Sensorausgangssignale von einem Teil der Mehrzahl von Halleffekt-Sensorelementen oder von allen der Mehrzahl von Halleffekt-Sensorelementen basieren.

Gemäß einem Ausführungsbeispiel umfasst das vorliegende Konzept ein Verfahren 100 zur Offsetkompensation eines Sensorsignals $S_0$ eines Hall-Sensor, mit folgenden Schritten:

Durchführen 110 einer ersten Offsetkompensation an dem Sensorsignal $S_0$ zum Bereitstellen eines vorkompen-

sierten Sensorsignals S, wobei bei der ersten Offsetkompensation ein in Bezug auf ein Versorgungssignal $S_{DD}$ linearer Anteil des Offsets in dem Sensorsignal beseitigt oder zumindest reduziert wird,

Ermitteln 120 einer Vielzahl N, mit $N \geqq 3$, von Sensorsignalwerten $S_N$ bei unterschiedlichen Offset-Messvorgängen und mit unterschiedlichen Versorgungssignalwerten $S_{DDN}$ innerhalb eines Zeitintervalls $\Delta t1$, wobei die Offset-Messvorgänge zeitlich so aufeinander folgend ausgeführt werden, dass während des Zeitintervalls $\Delta t1$ das auf den Hall-Sensor einwirkende Messmagnetfeld innerhalb eines Toleranzbereiches konstant ist,

Bestimmen 130 einer Fitting-Funktion $F(S_{DD})$ für das vorkompensierte Sensorsignal über dem Versorgungssignal $S_{DD}$ basierend auf den ermittelten N Sensorsignalwerten $S_N$, mit

$$F(S_{DD}) = \text{Konstanter Anteil} + \text{Linearer Anteil} + \text{Nicht-linearer Anteil}$$

wobei der nichtlineare Anteil der Fitting-Funktion auf einem Rest-Offsetanteil R in dem vorkompensierten Sensorsignal S basiert, und

(1) wobei der lineare Anteil der Fitting-Funktion auf dem (konstant anliegenden) Messmagnetfeld basiert, wenn das vorkompensierten Sensorsignal proportional zu einer erfassten Hall-Spannung des Hall-Sensors ist; und
(2) wobei der konstante Anteil der Fitting-Funktion auf dem (konstant anliegenden) Messmagnetfeld basiert, wenn das vorkompensierten Sensorsignal proportional zu dem einwirkenden Messmagnetfeld ist, das basierend auf der erfassten Hall-Spannung und der Empfindlichkeit des Hall-Sensors ermittelt wird;

Berechnen 140 eines Offset-reduzierten- Sensorsignalwerts $S_0$ basierend auf dem Anteil der ermittelten Fitting-Funktion, der auf dem (konstant anliegenden) Messmagnetfeld basiert; Erfassen 150 eines Sensorsignalwerts $S_N$ bei einem Versorgungssignalwert $S_{DDN}$;

Ermitteln 160 des Rest-Offsetanteils R des vorkompensierten Sensorsignals S bei dem Versorgungssignalwert $S_{DDN}$ als Differenz zwischen dem Sensorsignalwert $S_N$ und dem Offset-reduzierten Sensorsignalwert $S_0$; und Durchführen 170 einer Offsetkompensation an dem Sensorsignal S basierend auf dem ermittelten Offsetanteil R bei dem Versorgungssignalwert $S_{DDN}$.

Gemäß einem Ausführungsbeispiel umfasst das vorliegende Konzept ein weiteres Verfahren 200 zur Offsetkompensation eines Sensorsignals S eines Hall-Sensors, mit folgenden Schritten:

Ermitteln 210 eines ersten Sensorsignalwerts S1 des Sensorsignals S bei einem ersten Offsetmessvorgang basierend auf einem ersten Versorgungssignalwert $S_{DD1}$ und eines zweiten Sensorsignalwerts S2 des Sensorsignals bei einem zweiten Offsetmessvorgang basierend auf einem zweiten Versorgungssignalwert $S_{DD2}$ wobei der erste Versorgungssignalwert $S_{DD1}$ so gewählt ist, dass ein Rest-Offsetanteil R1 in dem ersten Sensorsignalwert S1 weniger als 50% des ersten Sensorsignalwerts S1 beträgt, und wobei der erste und der zweite Offset-Messvorgang zeitlich so aufeinander folgend ausgeführt werden, dass bei dem ersten und zweiten Offsetmessvorgang das auf den Hall-Sensor einwirkende Messmagnetfeld innerhalb eines Toleranzbereiches konstant ist;

Ermitteln 220 eines Offsetanteils R2 in dem Sensorsignal S für den zweiten Versorgungssignalwert $S_{DD2}$ als Differenz zwischen dem zweiten Sensorsignalwert $S_{DD2}$ und dem ersten Sensorsignalwert $S_{DD1}$; und

Durchführen 230 einer Offsetkompensation an dem Sensorsignal S basierend auf dem ermittelten Offsetanteil R bei dem zweiten Versorgungssignalwert $S_{DD2}$.

Durch eine Modulation bzw. Variation des Versorgungssignals eines Hall-Sensors lässt sich in dem daraus resultierenden Sensorausgangssignal eine Trennung des Nutzsignalanteils vom Offsetanteil während des Betriebs des Hall-Sensors erreichen. Der resultierende Verlauf des Sensorausgangssignals kann hinsichtlich der Komponenten, die auf den Offsetanteil und den Nutzsignalanteil zurückzuführen sind, ausgewertet werden.

Der Offsetanteil im Ausgangssignal eines Hall-Sensors ist stark von dem Versorgungssignal, z. B. der Versorgungsspannung oder dem Versorgungsstrom, abhängig, wobei für einen niedrigen Versorgungssignalwert der Offsetanteil in dem Sensorausgangssignal als vernachlässigbar angesehen werden kann, während der Offsetanteil in dem Sensorausgangssignal mit steigenden Versorgungssignalwerten "nicht linear" ansteigt. Demgegenüber ist die Empfindlichkeit eines Hall-Sensors direkt proportional zum angelegten Versorgungssignal. Unter der Annahme, dass während der Ermittlung des Offsetanteils in dem Sensorausgangssignal, das auf den Hall-Sensor einwirkende Messmagnetfeld innerhalb eines Toleranzbereichs konstant ist, kann erfindungsgemäß eine Trennung zwischen dem Nutzsignalanteil und dem Offsetanteil in dem Sensorausgangssignal im Betrieb erreicht werden, indem eine "Modulation" (d. h. eine Einstellung unterschiedlicher Werte) des Versorgungssignals vorgenommen wird. Der Offsetanteil in dem Sensorausgangssignal kann dann nahezu eliminiert bzw. zumindest stark reduziert werden, da der "quasi-Offset-freie" Messwert für das Sensorausgangssignal bei einem sehr niedrigen Versorgungssignalwert ermittelt werden kann, während anschließend im Normalbetrieb bei einem hohen Versorgungssignalwert der Offsetanteil bestimmt und aus dem Sensorausgangssignal eliminiert werden kann. Somit lässt sich die hohe Empfindlichkeit eines Hall-Sensors bei hohen Versorgungssignalwerten mit dem niedrigen Offsetanteil in dem Sensorausgangssignal bei einem niedrigen Versorgungssignalwert kombinieren, d. h. der Offsetanteil bei dem hohen Versorgungssignalwert lässt sich basierend auf der bekannten (hohen) Empfindlichkeit des Hall-Sensors und auf dem (quasi-Offset-freien) Messwert bei dem niedrigen Versorgungssignalwert während des Betriebs des Hall-Sensors bestimmen.

Im Folgenden werden die physikalischen Zusammenhänge hinsichtlich der Wirkungsweise und Funktionalität von Hall-Sensoren erörtert, auf denen das vorliegende Konzept zur Kompensation eines Offsetanteils in einem Sensorausgangssignal eines Hall-Sensors durch Modulation bzw. Variation des Versorgungssignals basiert.

In diesem Zusammenhang wird zunächst darauf hingewiesen, dass das vorliegende Konzept auf jegliche Typen bzw. Bauformen von Halleffekt-Sensorelementen (Hall-Sensoren), wie z. B. laterale oder vertikale Hall-Elemente, angewendet werden kann. Basierend auf einem Versorgungssignal, z. B. einer Versorgungsspannung oder einem Versorgungsstrom, wird ein Stromfluss durch den Hall-Sensor bewirkt, wobei der Hall-Sensor ein Ausgangssignal, z.B. eine Ausgangsspannung bzw. Hall-Spannung, liefert, wenn an dem Hall-Sensor eine zu dem Stromfluss senkrecht verlaufende äußere Magnetfeldkomponente anliegt bzw. der Hall-Sensor durchdringt. Diese Ausgangsspannung des Hall-Sensors ist proportional zum Produkt aus magnetischer Flussdichte der anliegenden externen Magnetfeldkomponente und dem Strom durch den Hall-Sensor. Das Ausgangssignal ist temperaturabhängig und weist häufig neben dem Nutzsignalanteil, der ausschließlich von dem anliegenden äußeren Magnetfeld abhängt, ferner einen (häufig auch temperaturabhängigen) sogenannten "Offsetanteil" auf.

Das nachfolgende Konzept zur Kompensation eines Offsetanteils im Sensorausgangssignals eines Hall-Sensors mittels Modulation bzw. Variation des Versorgungssignals kann dabei beispielsweise direkt auf das Sensorausgangssignal angewendet werden oder auch auf ein Hallsensorausgangssignal eines Hall-Sensors, das bereits einer sogenannten "Offset-Vorkompensation" unterzogen wurde. Um den meist großen und zudem stark temperaturabhängigen Offsetanteil im Sensorausgangssignal eines Hall-Sensor (Halleffekt-Sensorelements) zu kompensieren, finden unter anderem folgende auch kombinierbare Prinzipien Anwendung, wie z. B. das Spinning-Current-Prinzip (SC-Prinzip), das Prinzip der orthogonalen Paarbildung und/oder das Prinzip der Zwangssymmetrierung, wobei auch nach einer solchen Vorkompensation weiterhin ein temperaturabhängiger Rest-Offsetanteil in dem Sensorausgangssignal zumeist bestehen bleibt. Auch unter Verwendung der oben beispielhaft beschriebenen Vorkompensationsprinzipien verbleibt in dem resultierenden (vorkompensierten) Sensorausgangssignal i. A. weiterhin ein temperaturabhängiger Rest-Offsetanteil.

Das erfindungsgemäße Konzept zur Kompensation eines Offsetanteils in einem Hallsensorausgangssignal mittels Modulation bzw. Variation des Versorgungssignals ist somit auch auf bereits vorkompensierte Hallsensorausgangssignale anwendbar.

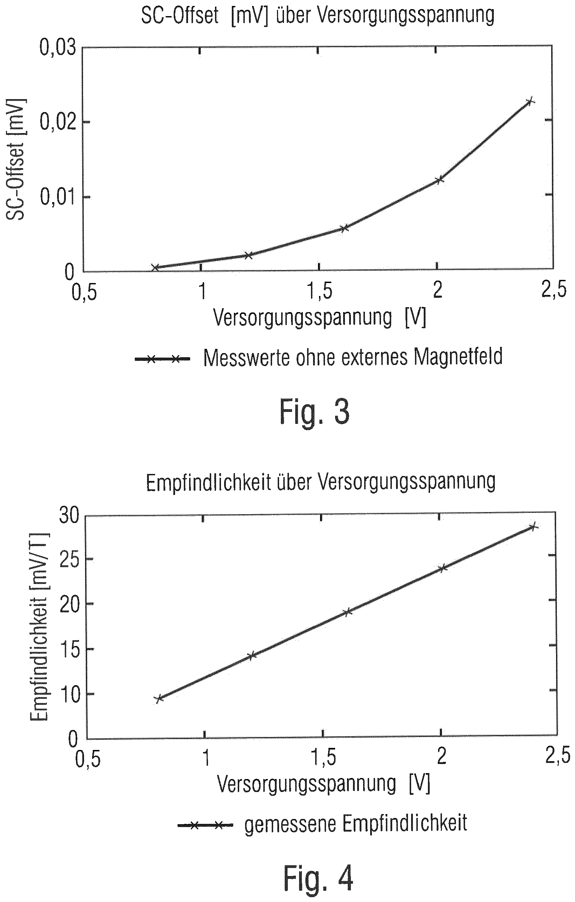

Wie nun in der graphischen Darstellung von Fig. 3 mit einem typischen Verlauf eines Offsetanteils (z. B. eines bereits "vorkompensierten" Hallsensorausgangssignals) eines Hall-Sensors über dem Versorgungssignal, z. B. der Versorgungsspannung oder auch einem Versorgungsstrom, weist der Offsetanteil (z.B. SC-Offset = Spinning-Currentvorkompensierte Offset) eines Hall-Sensors eine starke (nicht-lineare) Abhängigkeit von dem Versorgungssignal auf. In Fig. 3 sind die Messwerte bezüglich des Offsetanteils ohne einem extern anliegenden Magnetfeld über der Versorgungsspannung des Hall-Sensors beispielhaft dargestellt. Dieser typische Zusammenhang ergibt sich qualitativ sowohl für ein nicht-vorkompensiertes als auch für ein vorkompensiertes Sensorausgangssignal. Ohne Vorkompensation ist dem nichtlinearen Offset-Anteil noch ein linearer Offset-Anteil überlagert, wobei aber nach wie vor der Offset-Anteil bei einer niedrigen Versorgungsspannung kleiner ist als der Offset-Anteil bei einer dazu höheren Versorgungsspannung.

In der nachfolgenden Beschreibung und in den Figuren ist als Versorgungssignal eine Versorgungsspannung eines Hall-Sensors angegeben, wobei die Ausführungen gleichermaßen darauf anwendbar sind, wenn der Hall-Sensor mit einem Versorgungsstrom als Versorgungssignal gespeist wird. Ein Versorgungsstrom und eine Versorgungsspannung lassen sich z. B. mittels des (ohmschen) Widerstands bzw. Innenwiderstands des Hall-Sensors ineinander überführen. Diese Annahme ist auf alle Ausführungsbeispiele bzw. Verfahren und Verfahrensschritte des hier dargestellten Konzepts anwendbar.

Fig. 4 gibt nun in einer graphischen Darstellung den Zusammenhang zwischen der (spannungsbezogenen) Empfindlichkeit [mV/T] eines Hall-Sensors über der an dem Sensorelement anliegenden Versorgungsspannung [V] für eine Mehrzahl von gemessenen Empfindlichkeitswerten wieder. Wie der Fig. 4 zu entnehmen ist, weist die Empfindlichkeit eines Hall-Sensors (Halleffekt-Sensorelements) gegenüber dem Offsetanteil über der Versorgungsspannung (vgl. Fig. 3) eine direkte Proportionalität zur Versorgungsspannung an dem Hall-Sensor auf.

Basierend auf dem vorliegenden Konzept ist es nun nicht mehr erforderlich, zwischen den beiden folgenden Möglichkeiten zu wählen, nämlich (1.) eine hohe Versorgungsspannung zu verwenden, um eine hohe Empfindlichkeit bei gleichzeitig vergleichsweise hohem Offsetanteil zu erhalten, oder (2.) eine niedrige Versorgungsspannung zu verwenden, die eine niedrige resultierende Empfindlichkeit des Hall-Sensors aber mit einem vergleichsweise niedrigen Offsetanteil zur Folge hat. Wie die nachfolgenden Ausführungen nun insbesondere verdeutlichen werden, zeichnet sich das erfindungsgemäße Konzept dadurch aus, dass sich durch eine Modulation bzw. Variation des Versorgungssignals, d. h. der Versorgungsspannung oder des Versorgungsstroms, der Offsetanteil in dem Sensorausgangssignal des Hall-Sensors nahezu eliminieren oder zumindest stark reduzieren lässt. Ist nun gemäß dem vorliegenden Konzept der "Quasi" Offsetanteil-freie Messwert (Sensorausgangssignalwert) bekannt, so lässt sich anschließend im Normalbetrieb des Hall-Sensors bei hoher Versorgungsspannung der dortige Offsetanteil bestimmen und der resultierende Nutzsignalanteil (wirksame Anteil) des Hallsensorausgangssignals ermitteln. Dies kann angenommen werden, solange während der Ermittlung des Offsetanteils im Hallsensorausgangssignal das auf der Hall-Sensor einwirkende Messmagnetfeld innerhalb eines Toleranzbereichs konstant geblieben ist.

Bezug nehmend auf physikalische bzw. technische Grundlagen zu Hall-Sensoren ist, wie bereits oben angegeben, die (spannungsbezogene bzw. strombezogene) Empfindlichkeit eines Halleffekt-Sensorelements (Hall-Sensors) direkt proportional zur Versorgungsspannung. Dabei beruht der nicht-lineare Verlauf des Offsetanteils in dem Hallsensorausgangssignal über dem Versorgungssignal auf der Tatsache, dass beispielsweise bei einer Vorkompensation des Hallsensorausgangssignals bedingt durch das Spinning-Current-Prinzip lineare Offset-Ursachen bereits relativ stark reduziert bzw. eliminiert werden können. So bleiben jene Offsetanteile übrig, die ihren (elektronischen) Ursprung im Bereich der Raumladungszone (im Tiefenbereich) des Hall-Sensors haben.

Gemäß dem vorliegenden Konzept ist es nun möglich, für die verwendete Sensortechnologie, d. h. für den verwendeten Typ eines Hall-Sensors mit einem oder einer Mehrzahl von Halleffekt-Sensorelementen, eine typische Funktion bzw. einen funktionalen Zusammenhang zu bestimmen, mit der/dem der nicht-lineare Offsetanteil in dem Hallsensorausgangssignal über dem Versorgungssignal nachgebildet werden kann.

Wird nun diese ermittelte Funktion (für die Hall-Spannung als Hallsensorausgangssignal) um einen linearen Anteil, der dem "oben" konstanten externen Magnetfeld entspricht, ergänzt, kann diese Funktion verwendet werden, um den Offsetanteil und den Nutzsignalanteil in dem Hallsensorausgangssignal nachzubilden.

Ist diese Funktion auf eine bereits von der Hall-Spannung abgeleitete Größe bezogen, z. B. die über die Empfindlichkeit des Hall-Sensors berechnete Größe des anliegenden Magnetfelds, und wird diese Funktion um einen "konstanten" Anteil ergänzt, kann sie in diesem (alternativen) Fall verwendet werden, um wiederum den Offsetanteil und den Nutzsignalanteil in dem Hallsensorausgangssignal nachzubilden.

Im Folgenden wird im Allgemeinen auf den Fall eingegangen, dass die Funktion die Hall-Spannung (Sensorspannung) nachbildet, wobei die Ausführungen entsprechend anwendbar sind, wenn die Funktion eine von der Hall-Spannung abgeleitete Größe, z. B. das daraus über die Empfindlichkeit berechnete anliegende Magnetfeld nachbildet.

Die Versorgungsspannung (Sensorspannung) des Hall-Sensors wird nun moduliert bzw. variiert, d. h. das Sensorsignal nimmt eine Mehrzahl (zumindest zwei) unterschiedliche Werte an, wobei anschließend die typische Funktion "angefittet" wird, um so die gefittete Funktion bzw. Fitting-Funktion zu erhalten.

Als "Fitting" wird im Rahmen der vorliegenden Beschreibung eine sogenannte "Ausgleichsrechnung" in Form einer mathematischen Optimierungsmethode verstanden, um die Parameter einer vorgegebenen Funktion (Fitting-Funktion) zu bestimmen bzw. abzuschätzen. Unter einem Fitting bzw. Fit wird beispielsweise eine Funktionsanpassung verstanden, wobei auch etwaige Messfehler oder Unsicherheiten der Messpunkte berücksichtigt werden können. Eine mögliche Methode bzw. Vorgehensweise eines Fits ist die Methode der kleinsten Quadrate, wobei beispielsweise eine Gauß-verteilte Messunsicherheit angenommen wird. Natürlich können auch andere Vorgehensweisen und Algorithmen zur Bestimmung der Fitting-Funktion eingesetzt werden, soweit der Verlauf des Sensorausgangssignals oder einer davon abgeleiteten Größe ausreichend genau mit der Fitting-Funktion wiedergegeben wird.

Bildet nun beispielsweise die Fitting-Funktion das Sensorausgangssignal in Form der Hall-Spannung nach, so wird durch eine Betrachtung des linearen Anteils der Fitting-Funktion der annähernd Offset-freie Messwert, d. h. der Nutzsignalanteil des Sensorausgangssignals erhalten.

Bildet dagegen die Fitting-Funktion eine abgeleitete Größe der Hall-Spannung des Hall-Sensors nach, z. B. die über die Empfindlichkeit des Hall-Sensors bestimmte Größe des anliegenden externen Magnetfelds, so führt eine Betrachtung des "konstanten" Anteils der Fitting-Funktion zu dem annähernd Offset-freien Messwerts, d. h. dem Nutzsignalanteil des Hallsensorausgangssignals bzw. der davon abgeleiteten Größe.

Wird nun der Hall-Sensor jetzt wieder mit der hohen (vollen) Versorgungsspannung betrieben, so lässt sich der Offsetanteil bei der hohen Versorgungsspannung bestimmen, so dass mit diesem bestimmten Offsetanteil nun die weiteren Messwerte, d. h. Hallsensorausgangssignalwerte, bei der hohen Versorgungsspannung, die eine hohe Empfindlichkeit des Hall-Sensors zur Folge hat, korrigiert werden.

Entsprechend der vorliegenden Vorgehensweise, d. h. dem vorliegenden Konzept, wird nun bei einem (innerhalb eines Toleranzbereichs) konstanten externen Magnetfeld die Sensorspannung (d. h. das Versorgungssignal) moduliert und anschließend die typische Funktion (Fitting-Funktion) angefittet bzw. bestimmt.

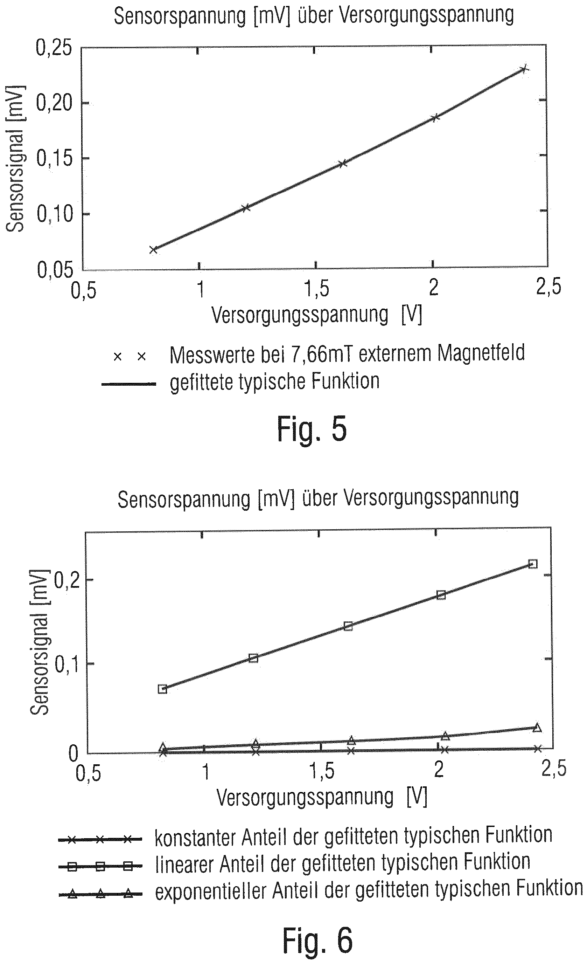

In Fig. 5 ist nun zur Verdeutlichung eine beispielhafte, graphische Darstellung eines typischen Verlaufs eines Sensorsignals (z. B. einer Hall-Spannung in mV-Bereich) über verschiedene Versorgungsspannungswerte in einem beispielhaften Versorgungsspannungsbereich dargestellt. Bei der in Fig. 5 dargestellten graphischen Darstellung liegt ein externes Magnetfeld mit einer beispielhaften Stärke (magnetische Flussdichte) von 7,66 mT an, wobei die Sensorspannung (Versorgungsspannung) von 0,6 V bis 2,4 V moduliert bzw. variiert wird. In Fig. 5 sind somit einerseits die (z.B. fünf) gemessenen Messwerte bei einem 7,66 mT externen Magnetfeld angegeben, sowie die erhaltene gefittete typische Funktion (Fitting-Funktion) als durchgezogene Linie. Die (roten) Kreuze sind somit die eigentlichen Messwerte, während die (blaue) Kurve die gefittete Funktion (Fitting-Funktion) darstellt. Die drei Komponenten der beispielhaften Fitting-Funktion, d. h. der lineare Anteil, der exponentielle Anteil und der konstante Anteil sind in Fig. 6 graphisch dargestellt.

Die Fitting-Funktion $F(S_{DD})$ für das vorkompensierte Sensorsignal über dem Versorgungssignal $S_{DD}$ wird basierend auf den ermittelten N Sensorsignalwerten $S_N$ ermittelt, mit einem konstanten Anteil, einem linearen Anteil und einem nicht-linearen Anteil, wobei der nichtlineare Anteil der Fitting-Funktion auf einem Rest-Offsetanteil R in dem vorkompensierten Sensorsignal S basiert.

Für die nachfolgenden Ausführungen wird nun wieder beispielhaft angenommen, dass die Fitting-Funktion das Sensorausgangssignal in Form der (z.B. aufbereiteten) Hall-Spannung des Hall-Sensors nachbildet.

Fig. 6 zeigt nun eine graphische Darstellung der drei Komponenten der Fitting-Funktion für das Sensorsignal (Hall-Spannung) über der Versorgungsspannung, wobei der (rote) mit Kreuzen versehene Verlauf den konstanten Anteil "a" der gefitteten typischen Funktion (Fitting-Funktion), der (blaue) mit Kästchen versehene Verlauf den linearen Anteil "bx" (Nutzsignalanteil) der gefitteten Funktion, und der (grüne) mit Dreiecken versehene Verlauf dem exponentiellen Anteil "$e^{dx}$" bzw. "$dx^n$" der gefitteten typischen Funktion wiedergibt. Der konstante Anteil "a" ist bei dem dargestellten Beispiel ungefähr null, da das Sensorausgangssignal im vorliegenden Fall beispielsweise ein (mittels Spinning-Current) vorkompensiertes Sensorausgangssignal ist. Der lineare Anteil "bx" ist proportional zum anliegenden, externen Magnetfeld, d. h. das externe Magnetfeld kann über die bekannte Empfindlichkeit des Hall-Sensors aus dem linearen Anteil des Sensorausgangssignals berechnet bzw. ermittelt werden. Der exponentielle Anteil "$e^{dx}$" bzw. "$dx^n$" der Fitting-Funktion stellt den Offsetanteil in dem Sensorausgangssignal dar. Wird nun der lineare Anteil "bx" der Fitting-Funktion (die die Hall-Spannung nachbildet) betrachtet, so wird das (nahezu) Offset-freie Ausgangssignal des Hall-Sensors erhalten.

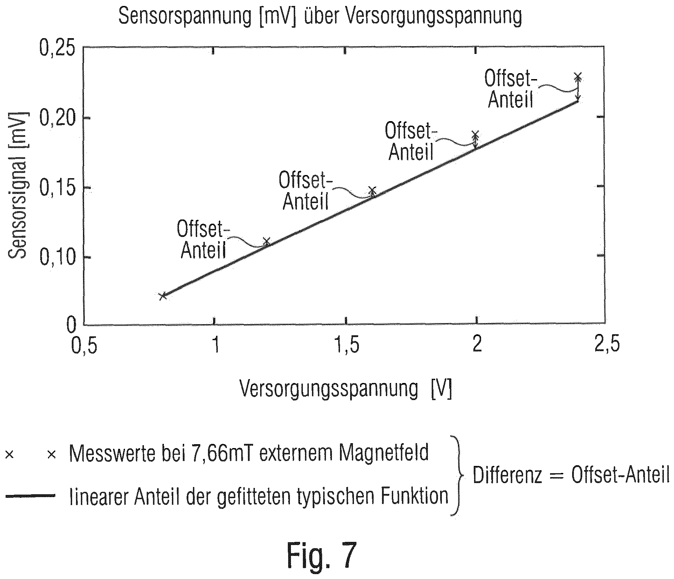

Fig. 7 zeigt nun eine graphische Darstellung des Sensorausgangssignals (der Hall-Spannung) über der Versorgungsspannung, wobei die (roten) Kreuze die Messwerte (in mV) bei dem konstanten, externen Magnetfeld (z. B. 7,66 mT) angeben, und die durchgezogene (blaue) Linie den linearen Anteil "bx" der gefitteten typischen Funktion (Fitting-Funktion) angeben. Aus der graphischen Darstellung von Fig. 7 ist ersichtlich, dass der Offset-Anteil die Differenz zwischen den Messwerten für das externe Magnetfeld und dem linearen Anteil der Fitting-Funktion ist, wobei dieser Offset-Anteil mit dem vorliegenden Kompensationsverfahren reduziert werden kann.

Basierend aus den Quotienten zwischen Messwert (gemessener bzw. ermittelter Sensorspannung) und Empfindlichkeit des Hall-Sensors wird der Wert für das anliegende konstante externe Magnetfeld erhalten. Mit anderen Worten wird die erhaltene Sensorspannung durch die Empfindlichkeit des Hall-Sensors geteilt, erhält man das über die Versorgungsspannung konstante externe Magnetfeld. Die Empfindlichkeit eines Hall-Sensors kann beispielsweise im Betrieb des Hall-Sensors mittels Spulen zur Erzeugung eines vorgegebenen Magnetfelds in dem Hall-Sensor oder mittels eines Serientests und entsprechender Hinterlegung typischer Werte in einem dem Hall-Sensor zugeordneten Speicher erhalten werden.

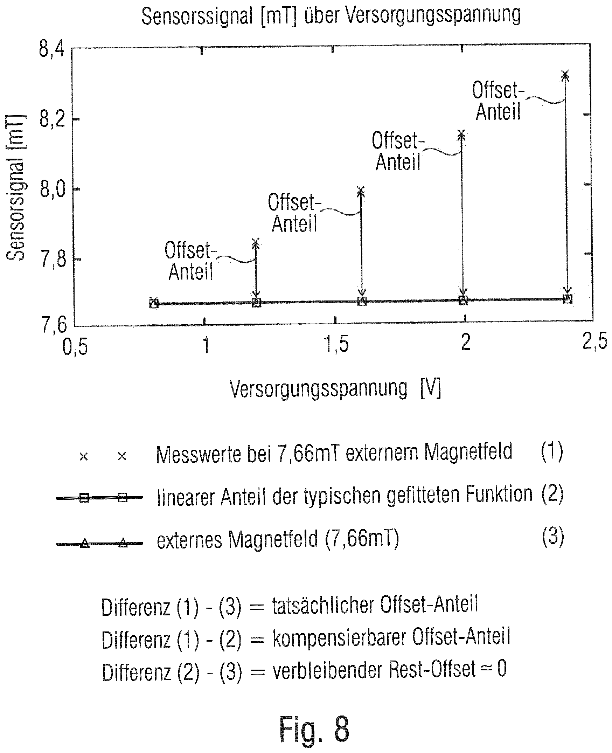

Die graphische Darstellung in Fig. 8 zeigt nun zum Vergleich das direkt gemessene Signal als Messwerte (Kreuze), den linearen Anteil der gefitteten Funktion (Quadrate) und das anliegende, externe Magnetfeld (Dreiecke). Die Messwerte (in mT) sowie der lineare Anteil der gefitteten Funktion (in mT) in Fig. 8 wurden über die Empfindlichkeit des Hall-Sensors aus den Messwerten (in mV) sowie aus dem linearen Anteil der gefitteten Funktion (in mV) von Fig. 7 berechnet.

Aus der graphischen Darstellung von Fig. 8 ist ersichtlich, dass der (tatsächliche) Offset-Anteil in dem Sensorsignal die Differenz zwischen den Messwerten (Kreuze) für das externe Magnetfeld und dem externen Magnetfeld (Dreiecke) ist (Differenz Messwerte - Externes Feld = Offset).

Aus der graphischen Darstellung von Fig. 8 ist ferner ersichtlich, dass der "kompensierbare" Offset-Anteil in dem Sensorsignal die Differenz zwischen den Messwerten für das externe Magnetfeld und dem linearen Anteil der Fitting-Funktion ist (Differenz Messwerte - linearer Anteil = kompensierbarer Anteil). Dieser Offset-Anteil kann mit dem vorliegenden Kompensationsverfahren kompensiert oder zumindest reduziert werden.

Ferner gibt die Differenz zwischen dem linearen Anteil der Fitting-Funktion und dem anliegenden externen Magnetfeld den verbleibenden Offset (Rest-Offset) an, der nach Ausführung des vorliegenden Kompensationsverfahrens bleibt (Differenz linearer Anteil - Externes Feld = Verbleibender (Rest) Offset nach dem Kompensationsverfahren).

Wie nun der graphischen Darstellung in Fig. 8 zu entnehmen ist, ist es mit dem vorliegenden Konzept möglich, den Nutzsignalanteil (linearer Anteil der Fitting-Funktion) von dem Offsetanteil des Sensorausgangssignals zu trennen. Mit dem nun bekannten (annähernd) Offset-freien Messwert (Sensorsignalwert) kann der Offsetanteil bei einer hohen Versorgungsspannung bestimmt werden. Dazu wird erneut mit einer hohen Versorgungsspannung (einem hohen Versorgungsspannungswert) das Sensorausgangssignal (der Sensorausgangssignalwert) gemessen/ermittelt. Unter der Annahme, dass das externe, anliegende Magnetfeld während dieser Zeit für die beiden Messvorgänge (innerhalb eines Toleranzbereichs) konstant geblieben ist, kann so der Offsetanteil bei der hohen Versorgungsspannung bestimmt werden. Die weiteren Messwerte (Sensorausgangssignalwerte) bei der hohen Versorgungsspannung können jetzt um den (ermittelten) Offsetanteil korrigiert werden. Mit dem vorliegenden Konzept ist es also möglich, die hohe Empfindlichkeit eines Hall-Sensors bei dessen hoher Versorgungsspannung mit dem niedrigen Offsetanteil bei einer niedrigen Versorgungsspannung zu kombinieren.

Die Annahme bzw. Randbedingung, dass der Offsetanteil während den beiden Messungen (den Offset-Messungen siehe oben) innerhalb des Toleranzbereichs konstant geblieben ist, lässt sich z. B. dadurch überprüfen, dass zuerst eine Messung des Sensorausgangssignals mit einer hohen Versorgungsspannung durchgeführt wird, anschließend mit einer niedrigen Versorgungsspannung der Offsetanteil bestimmt wird und danach wieder mit einer hohen Versorgungsspannung gemessen wird. Dabei sollte der Offsetanteil bei der hohen Versorgungsspannung im Wesentlichen gleich geblieben sein, wenn das extern anliegende Magnetfeld (innerhalb des Toleranzbereichs) konstant geblieben ist.

Wie die vorhergehenden Ausführungen gezeigt haben, kann das erfindungsgemäße Konzept des Bestimmens einer Fitting-Funktion des Sensorsignals beispielsweise auf die gemessene Hall-Spannung bezogen werden. Durch den proportionalen Zusammenhang von Versorgungsspannung und Empfindlichkeit stellt der lineare Anteil der gefitteten Funktion dann (zumindest näherungsweise) den Nutzsignalanteil in dem Sensorausgangssignal dar. Das gezeigte Verfahren bzw. das vorliegende Konzept lässt sich aber auch anwenden, wenn die Sensorspannung (Hall-Spannung) bereits in eine andere Größe verarbeitet wurde, z. B. bereits in das zu bestimmende anliegende Magnetfeld (die zu bestimmende Magnetfeldstärke) umgerechnet wurde. Für diesen Fall kann natürlich eine andere typische Funktion (Fitting-Funktion) verwendet werden, wobei dann, wenn die Fitting-Funktion das aus dem Sensorausgangssignal abgeleitete Magnetfeld darstellt, der konstante Anteil der Fitting-Funktion als das Messsignal (der Nutzsignalanteil) verwendet werden kann, da in Bezug auf das zu erfassende Magnetfeld (d. h. im mT-Bereich) das Signal, d.h. der Nutzsignalanteil, über der Versorgungsspannung konstant ist.

Das erfindungsgemäße Konzept ist natürlich auch dann anzuwenden, wenn das Sensorausgangssignal (z. B. die Hall-Spannung) in eine weitere Größe umgerechnet wurde, wobei dies dann entsprechend bei der Fitting-Funktion und den daraus erhaltenen Parametern zu berücksichtigen ist.

Im Folgenden wird unter Berücksichtigung der obigen Ausführungen zu den Figuren 3 bis 8 nochmals das in Fig. 1 dargestellte Flussdiagramm des vorliegenden Konzepts bzw. Verfahrens 100 zur Offset-Kompensation eines Sensorsignals $S_0$ eines Hall-Elements im Detail erörtert.

Nachfolgend wird auf einen Hall-Sensor Bezug genommen, wobei ein Hall-Sensor eines oder mehrere Halleffekt-Sensorelemente aufweisen kann, wobei der Hall-Sensor das Sensorsignal bzw. Sensorausgangssignal $S_0$ bereitstellt, das in Form der abgegriffenen Hall-Spannung oder einer davon abgeleiteten Größe (als aufbereitete Hall-Spannung) vorliegen kann.

Bei dem Schritt 110 wird zunächst eine erste Offset-Kompensation (Vorkompensation) an dem Sensorsignal $S_0$ durchgeführt, um ein vorkompensiertes Sensorsignale S bereitzustellen, wobei bei der (optionalen) ersten Offset-Kompensation ein in Bezug auf ein Versorgungssignal $S_{DD}$ (für den Hall-Sensor) linearer Anteil des Offsets in dem Sensorsignale S beseitigt oder zumindest reduziert wird. Zur ersten Offset-Kompensation (Vorkompensation) des Sensorsignals können beispielsweise die oben angesprochenen Offset-Reduzierungsprinzipien, wie das Spinning-Current-Prinzip, das Prinzip der orthogonalen Paarbildung und/oder das Prinzip der Zwangssymmetrierung bzw. beliebige Kombinationen desselben oder vergleichbare Kompensationsprinzipien eingesetzt werden.

Bei dem weiteren Schritt 120 wird eine Vielzahl N mit N ≥ 3, von Sensorsignalwerten $S_0$ bei unterschiedlichen Offset-Messvorgängen und mit unterschiedlichen Versorgungssignalwerten $S_{DDN}$ des Versorgungssignals $S_{DD}$ innerhalb eines Zeitintervalls $\Delta t1$ ermittelt, wobei die Offset-Messvorgänge zeitlich so (kurz) aufeinanderfolgend ausgeführt werden, dass während des Zeitintervalls $\Delta t1$ das auf dem Hall-Sensor einwirkende Messmagnetfeld innerhalb eines Toleranzbereichs konstant ist.

Die Vielzahl N, mit N ≥ 3, 5 oder 10, von Sensorsignalwerten $S_N$ ist erforderlich, um nachfolgend den Signalverlauf des Ausgangssignals S über den Versorgungssignalwerten $S_{DDN}$ ausreichend exakt nachbilden zu können. Die Vielzahl N, mit N ≥ 3, 5 oder 10, von Sensorsignalwerten $S_N$ wird beispielsweise innerhalb eines Offset-Messzeitintervalls $\Delta t1$ ermittelt, wobei das Messintervall abhängig von den verwendeten Hall-Sensortypen und der mit dem Hall-Sensor verschalteten digitalen und/oder analogen Schaltungsanordnung und deren Verarbeitungs- bzw. Betriebsfrequenz (f) von beispielsweise 1 Hz bis 10 MHz einen Wert in einem Bereich zwischen 1 s und 0,1 μs (1/f) aufweisen kann.

Bei einem Schritt 130 wird dann eine "Fitting-Funktion" $F(S_{DD})$ für das vorkompensierte Sensorsignal S über dem Versorgungssignal $S_D$ basiert auf den ermittelten N Sensorsignalwerten $S_N$ bestimmt. Dabei weist die Fitting-Funktion $F(S_{DD})$ beispielsweise folgende Form auf:

$$F(S_{DD}) = \text{Konstanter Anteil} + \text{Linearer Anteil} + \text{Nicht-linearer Anteil}$$

$$f(x) = a + bx + e^{dx},$$

oder

$$f(x) = a + bx + dx^n \dots \text{(Taylor-Reihe)},$$

mit $x = S_{DD}$, wobei der nicht-lineare Anteil der Fitting-Funktion $F(S_{DD})$ auf einem Rest-Offsetanteil R in dem vorkompensierten Sensorsignal S basiert.

Abhängig davon, ob nun das vorkompensierte Sensorsignal S beispielsweise die ermittelte Hall-Spannung des Hall-Sensors oder (alternativ) eine davon abgeleitete Größe nachbildet, wie z. B. die Größe des über der Empfindlichkeit des Hall-Sensors berechneten externen Magnetfelds, kann nun folgende Fallunterscheidung getroffen werden.

Bildet das Sensorsignal S bzw. die daraus erhaltene Fitting-Funktion die Hall-Spannung des Hall-Sensors nach bzw. wenn das vorkompensierte Sensorsignal proportional zu einer erfassten Hall-Spannung des Hall-Sensors ist, basiert der lineare Anteil der Fitting-Funktion auf dem (konstant anliegenden) externen Messmagnetfeld.

Wenn nun das vorkompensierte Sensorsignal proportional zu dem einwirkenden Messmagnetfeld ist, d. h. der Wert des Messmagnetfelds über die Empfindlichkeit des Hall-Sensors aus der erfassten Hall-Spannung bereits berechnet wurde, basiert der konstante Anteil der Fitting-Funktion auf dem (konstant anliegenden) Messmagnetfeld.

Bei dem Schritt 140 wird nun der (nahezu Offset-freie bzw. zumindest Offset-reduzierte) Sensorsignalwert S1, z. B. als Offset-Korrekturwert, basierend auf dem Anteil der ermittelten Fitting-Funktion berechnet bzw. ermittelt, der auf dem (konstant anliegenden) Messmagnetfeld basiert, d. h. entsprechend den beiden oben angegebenen Alternativen, wobei die erste Alternative den linearen Anteil und die zweite Alternative den konstanten Anteil der Fitting-Funktion verwendet.

Bei dem Schritt 150 wird nun, z. B. während des Betriebs des Hall-Sensors, ein Sensorsignalwert $S_N$ bei einem Versorgungssignalwert $S_{DDN}$ erfasst. Bei einem Schritt 160 wird nun der Rest-Offsetanteil R des vorkompensierten Sensorsignals S bei dem Versorgungssignalwert $S_{DDN}$ als Differenz zwischen dem Sensorsignalwert $S_N$ und dem berechneten Offset-reduzierten Sensorsignalwert S0 ermittelt bzw. berechnet. Der ermittelte Rest-Offsetanteil R des vorkompensierten Sensorsignals S kann dann bei diesem Versorgungssignalwert $S_{DDN}$ als Offset-Korrekturwert für die weitere Offset-Kompensation des Offsetanteils in dem Sensorausgangssignal S verwendet werden.

Die Ausführungsbeispiele des erfindungsgemäßes Konzepts zur Offsetkompensation sind auf Ausgestaltungen anwendbar, bei denen der Hall-Sensor ein Halleffekt-Sensorelement oder eine Mehrzahl von (z.B. paarweise angeordneten) Halleffekt-Sensorelementen aufweist. Sollte nun der Hall-Sensor zumindest ein erster Hall-Sensor zum Bereitstellen eines ersten Hall-Sensorsignals und ein zweites Hall-Sensorelement zum Bereitstellen eines zweiten Hall-Sensorsignals aufweisen, kann das Sensorsignal bzw. Sensorausgangssignal des Hall-Sensors auf einer Kombination des ersten und zweiten Hall-Sensorsignals basieren. Alternativ kann das Sensorsignal auf einer Kombination eines ersten aufbereiteten Sensorsignals und einem zweiten aufbereiteten Sensorsignal basieren, die von dem ersten Hall-Sensorsignal bzw. dem zweiten Hall-Sensorsignal abgeleitet sind.

Alternativ ist es ferner möglich, dass für den Fall, wenn der Hall-Sensor eine Mehrzahl von Hall-Sensoren aufweist, das hier vorgestellte Verfahren zur Offset-Kompensation auf die einzelnen Hall-Sensorsignale der Hall-Sensoren bzw. auf die entsprechend aufbereiteten Hall-Sensorsignale anwendbar ist. Das vorgestellte Verfahren zur Offset-Kompensation kann somit auf alle erhaltenen Hall-Sensorsignale unabhängig bzw. getrennt voneinander angewendet werden.

Eine Mehrzahl von Hall-Sensoren kann beispielsweise dann eingesetzt werden, wenn der Hall-Sensor mit dem zumindest ersten und zweiten Hall-Sensor als ein Winkelsensor oder Positionssensor ausgebildet ist.

Gemäß einem weiteren optionalen Schritt des vorliegenden Verfahrens kann ferner eine momentane Temperatur $T_0$ an dem Hall-Sensor erfasst werden, wobei die Schritte des Ermittelns 160 des Rest-Offsetanteils R und des Durchführens 170 der Offset-Kompensation wiederholt werden, wenn eine Änderung der momentanen Temperatur T0 zu einer (unmittelbar) vorhergehend durchgeführten Offset-Kompensation von zumindest 1°C, 2°C oder 5°C erfasst wird. Da der in dem Sensorausgangssignal vorhandene Offsetanteil temperaturabhängig ist, kann optional eine Ermittlung des Rest-Offsetanteils R immer dann durchgeführt werden, wenn eine "signifikante" Änderung der Umgebungs- bzw. Halbleitertemperatur des Halbleitersubstrats mit den Hall-Elementen erfasst wird, um eine Änderung des Offsetanteils aufgrund der vorliegenden Temperaturänderung bei nachfolgenden Offset-Kompensationsvorgängen berücksichtigen zu können. Mit anderen Worten bedeutet dies also, dass der bestimmte Rest-Offsetanteil R solange verwendet werden kann, bis eine signifikante Temperaturänderung von z. B. zumindest 1°C, 2°C oder 5°C ermittelt wurde.

Gemäß Ausführungsbeispielen kann die erste Offset-Kompensation (Vorkompensation) gemäß Schritt 110 beispielsweise mittels eines Spinning-Current-Verfahrens durchgeführt werden, um das vorkompensierte Sensorsignal zu erhalten. Alternativ oder zusätzlich zu dem Spinning-Current-Verfahren zur Vorkompensation kann ferner bei der ersten Offset-Kompensation ein Verfahren zur orthogonalen Paarbildung und/oder ein Verfahren zur Zwangssymmetrierung angewendet bzw. durchgeführt werden.

Basierend auf dem erhaltenen bzw. ermittelten Rest-Offsetanteil R kann ferner bei einem weiteren optionalen Schritt ein Funktionstest des Hall-Sensors und einer nachgeschalteten Sensorsignal-Auswerteschaltung in Betrieb mittels einer Plausibilitätsüberprüfung des ermittelten Rest-Offsetanteils R in dem (vorkompensierten) Sensorsignal S des Hall-Sensors durchgeführt werden. Da die Offsetanteile der Hall-Sensoren im Betrieb bekannt sind, können dadurch Fehler im System, z. B. in einer dem Hall-Sensor nachgeschalteten Auswerteschaltung, erkannt werden. Dies ist möglich, da zwischen einem Sensoroffset-Drift und einem Verstärkeroffset-Drift unterschieden werden kann. Während des Betriebs des Hall-Sensors können die Schritte des Ermittelns 160 des Rest-Offsetanteils R und des Durchführens 170 der Offset-Kompensation in vorgegebenen (zeitlich beabstandeten) Zeitintervallen oder auch kontinuierlich während des Betriebs des Hall-Sensors durchgeführt werden.

Bezüglich Ausführungsbeispielen des vorliegenden Konzepts kann das Versorgungssignal $S_{DD}$ zum Bereitstellen des Versorgungssignalwerte $S_{DD1}$, $S_{DD2}$ bzw. $S_{DDN}$ als eine Versorgungsspannung oder ein Versorgungsstrom in den Hall-Sensor eingespeist werden.

Im Folgenden wird unter Berücksichtigung der obigen Ausführungen zu den Figuren 3 bis 8 nochmals das in Fig. 2 dargestellte Flussdiagramm des vorliegenden Konzepts bzw. Verfahrens zur Offset-Kompensation eines Sensorsignals $S_0$ eines Hall-Elements durch Modulation bzw. Variation des Versorgungssignals im Detail erörtert. Um beispielsweise Rechenleistung einer Sensoranordnung zum Durchführen des erfindungsgemäßen Konzepts bzw. des erfindungsgemäßen Verfahrens verhindern zu können, d. h., um die Anforderungen an das Sensorsystem hinsichtlich der erforderlichen Rechenleistung möglichst niedrig halten zu können, können folgende vereinfachende Betrachtungen bzw. Annahmen gegenüber dem in Fig. 2 dargestellten Kompensationsverfahren getroffen werden, ohne die Effektivität und Genauigkeit der resultierenden Offset-Kompensation übermäßig zu beeinträchtigen.

Das Verfahren 200 zur Offsetkompensation eines Sensorsignals S bzw. eines Sensorausgangssignals eines Hall-Sensors oder einer davon abgeleiteten Größe weist folgende Schritte auf.

Bei dem Schritt 210 wird ein erster Sensorsignalwert S1 des Sensorsignals S bei einem ersten Offsetmessvorgang basierend auf einem ersten Versorgungssignalwert $S_{DD1}$ des Versorgungssignals $S_{DD}$ und ein zweiter Sensorsignalwert S2 des Sensorsignals bei einem zweiten Offsetmessvorgang basierend auf einem zweiten Versorgungssignalwert $S_{DD2}$ des Versorgungssignals $S_{DD}$ ermittelt. Der erste Versorgungssignalwert $S_{DD1}$ ist nun so gewählt, dass ein Rest-Offsetanteil R1 in dem ersten Sensorsignalwert S1 weniger als 50% des ersten Sensorsignalwerts S1 beträgt, wobei der erste und der zweite Offset-Messvorgang zeitlich so aufeinander folgend ausgeführt werden, dass bei dem ersten und zweiten Offsetmessvorgang das auf den Hall-Sensor einwirkende Messmagnetfeld innerhalb eines Toleranzbereiches konstant ist.

Dann wird bei dem Schritt 220 ein Offsetanteil R2 in dem Sensorsignal S für den zweiten Versorgungssignalwert $S_{DD2}$ als Differenz zwischen dem zweiten Sensorsignalwert $S_{DD2}$ und dem ersten Sensorsignalwert $S_{DD1}$ ermittelt, wobei bei dem Schritt 230 eine Offset-kompensation an dem Sensorsignal S basierend auf dem ermittelten Offsetanteil R bei dem zweiten Versorgungssignalwert $S_{DD2}$ durchgeführt wird.

Bei dem Schritt 220 des Ermittelns des ersten Sensorsignalwerts S1 wird der erste Versorgungssignalwert $S_{DD1}$ um einen Faktor von zumindest 2, 3 oder 5 kleiner als der zweite Versorgungssignalwert $S_{DD2}$ gewählt wird. Der niedrige (erste) Versorgungssignalwert wird z.B. kleiner oder gleich ($\leq$) 50%, 30%, 20% oder 10% als der höhere (zweite) Versorgungssignalwert gewählt

Gemäß einem weiteren optionalen Schritt des vorliegenden Verfahrens kann ferner eine momentane Temperatur $T_0$ an dem Hall-Sensor erfasst werden, , wobei die Schritte des Ermittelns des Rest-Offsetanteils R1 und des Durchführens einer zweiten Offsetkompensation wiederholt werden, wenn eine Änderung der momentanen Temperatur $T_0$ von zumindest 1°C, 2°C oder 5°C zu einer (z.B. unmittelbar) vorhergehend durgeführten zweiten Offsetkompensation erfasst wird. Da der in dem Sensorausgangssignal vorhandene Offsetanteil temperaturabhängig ist, kann optional eine Ermittlung des Rest-Offsetanteils R1 immer dann durchgeführt werden, wenn eine "signifikante" Änderung der Umgebungs- bzw. Halbleitertemperatur des Halbleitersubstrats mit den Hall-Elementen erfasst wird, um eine Änderung des Offsetanteils aufgrund der vorliegenden Temperaturänderung bei nachfolgenden Offset-Kompensationsvorgängen berücksichtigen zu können. Mit anderen Worten bedeutet dies also, dass der bestimmte Rest-Offsetteil R solange verwendet werden kann, bis eine signifikante Temperaturänderung von z.B. zumindest 1°C, 2°C oder 5°C ermittelt wurde.

EP 3 349 027 B1

Bei dem Schritt 210 wird wobei der erste Sensorsignalwert S1 bei dem ersten Offsetmessvorgang und der zweite Sensorsignalwert S2 bei dem zweiten Offsetmessvorgang innerhalb eines Offset-Messzeitintervalls Δt1 bereitgestellt, wobei ein Test-Sensorsignalwerts TS1 mit dem ersten Versorgungssignalwert $S_{DD1}$ innerhalb des Mess-Zeitintervalls Δt1 nach dem ersten und zweiten Offsetmessvorgang erfasst wird, und wobei eine Übereinstimmung (innerhalb eines Toleranzbereichs) des ersten Sensorsignalwerts S1 und des Test-Sensorsignalwerts TS1 das Vorliegen einer konstanten Temperatur und/oder eines konstanten einwirkenden Messmagnetfelds während des Messintervalls Δt1 angibt.

Die Sensorsignalwerten S1, S2 werden bei unterschiedlichen Offset-Messvorgängen und mit unterschiedlichen Versorgungssignalwerten $S_{DDN}$ des Versorgungssignals $S_{DD}$ innerhalb eines Zeitintervalls Δt1 ermittelt, wobei die Offset-Messvorgänge zeitlich so (kurz) aufeinanderfolgend ausgeführt werden, dass während des Zeitintervalls Δt1 das auf dem Hall-Sensor einwirkende Messmagnetfeld innerhalb eines Toleranzbereichs konstant ist. Das Messintervall ist beispielsweise abhängig von den verwendeten Hall-Sensortypen und der mit dem Hall-Sensor verschalteten digitalen und/oder analogen Schaltungsanordnung und deren Verarbeitungs- bzw. Betriebsfrequenz (f) von beispielsweise 1 Hz bis 10 MHz und kann einen Wert in einem Bereich zwischen 1 s und 0,1 μs (1/f) aufweisen.

Das Verfahren 200 kann ferner eine Schritt des Durchführens einer Offset-Vorkompensation an dem Sensorsignal S vor dem Schritt des Ermittelns des ersten und zweiten Sensorsignalwerts S1, S2, wobei die Offset-Vorkompensation mittels eines Spinning-Current-Verfahrens oder mittels eines Verfahrens zur orthogonalen Paarbildung und/oder mittels eines Verfahrens zur Zwangssymmetrierung durchgeführt wird, um ein vorkompensiertes Sensorsignal S zu erhalten.

Basierend auf dem erhaltenen bzw. ermittelten Rest-Offsetanteil R kann ferner bei einem weiteren optionalen Schritt ein Funktionstest des Hall-Sensors und einer nachgeschalteten Sensorsignal-Auswerteschaltung in Betrieb mittels einer Plausibilitätsüberprüfung des ermittelten Rest-Offsetanteils R in dem (vorkompensierten) Sensorsignal S des Hall-Sensors durchgeführt werden. Da die Offsetanteile der Hall-Sensoren im Betrieb bekannt sind, können dadurch Fehler im System, z. B. in einer dem Hall-Sensor nachgeschalteten Auswerteschaltung, erkannt werden. Dies ist möglich, da zwischen einem Sensoroffset-Drift und einem Verstärkeroffset-Drift unterschieden werden kann. Während des Betriebs des Hall-Sensors können die Schritte des Ermittelns 160 des Rest-Offsetanteils R und des Durchführens 170 der Offset-Kompensation in vorgegebenen (zeitlich beabstandeten) Zeitintervallen oder auch kontinuierlich während des Betriebs des Hall-Sensors durchgeführt werden.

Gemäß einem weiteren Ausführungsbeispiel können die Schritte des Ermittelns des Rest-Offsetanteils R1 und des Durchführens der zweiten Offsetkompensation ferner in vorgegebenen, zeitlich beabstandeten Zeitintervallen während des Betriebs des Hall-Sensors durchgeführt werden. Alternativ können die Schritte des Ermittelns des Rest-Offsetanteils und des Durchführens der zweiten Offsetkompensation kontinuierlich im Betrieb des Hall-Sensors durchgeführt werden. Ferner kann das Versorgungssignal $S_{DD}$ zum Bereitstellen Versorgungssignalwerte $S_{DD1}$, $S_{DD2}$ als eine Versorgungsspannung oder ein Versorgungsstrom in den Hall-Sensor eigespeist werden.

Gemäß einem weiteren Ausführungsbeispiel kann der Hall-Sensor zumindest ein erstes Hall-Sensorelement zum Bereitstellen eines ersten Hall-Sensorsignals und ein zweites Hall-Sensorelement zum Bereitstellen eines zweiten Hall-Sensorsignals aufweist, wobei das Sensorsignal auf einer Kombination des ersten und zweiten Hall-Sensorsignals basiert, oder wobei das Sensorsignal auf einer Kombination eines ersten aufbereiteten Sensorsignals und s zweiten aufbereiteten Sensorsignals, die von dem ersten und dem zweiten Hall-Sensorsignal abgeleitet sind, basieren kann. Das erste Hall-Sensorelement und das zweite Hall-Sensorelement können z.B. einen Winkelsensor oder einen Positionssensor bilden.

Betrachtet man eine mögliche typische Funktion F(x): a + bx + $e^{dx}$ (die im obigen Beispiel verwendet wurde), so geht für kleine Versorgungsspannungen den Term $e^{dx}$ gegen null. Der konstante Anteil der typischen Funktion ist in der Regel sowieso sehr klein, da der lineare Anteil des Offsets bereits durch das SC-Prinzip kompensiert wurde. Es ist also möglich mit einer einzigen Messung bei niedriger Versorgungsspannung das externe Magnetfeld mit deutlich reduziertem Offset zu messen. Lediglich der konstante Anteil und der exponentielle Anteil bleibt als Rest-Offset zurück, sind aber vernachlässigbar klein.

In der praktischen Anwendung bedeutet das, dass das externe Magnetfeld mit niedriger Versorgungsspannung gemessen wird. Hierdurch erhält man einen Messwert mit sehr niedrigem Offset, der zu null angenommen wird. Anschließend wird die Versorgungsspannung wieder erhöht und erneut gemessen. Jetzt enthält das Messsignal das eigentliche Magnetfeld und den relativ großen Offset. Unter der Annahme, dass das externe Magnetfeld während dieser Zeit konstant geblieben ist, kann so der Offset bei hoher Versorgungsspannung bestimmt werden. Die weiteren Messwerte bei hoher Versorgungsspannung können jetzt um den Offset korrigiert werden. Man kann also die hohe Empfindlichkeit bei hoher Versorgungsspannung mit dem niedrigen Offset bei niedriger Versorgungsspannung kombinieren.

Mit dem bekannten, annähernd Offset-freien Messwert (Sensorausgangssignalwert) bei einem niedrigen Versorgungssignalwert kann also der Offsetanteil in dem Sensorausgangssignal bei einem hohen Versorgungssignalwert bestimmt werden. Dazu wird nun das Sensorausgangssignal erneut mit einem hohen Versorgungssignalwert bestimmt bzw. gemessen, wobei die Annahme einzuhalten ist, dass das externe Magnetfeld (extern anliegende Messmagnetfeld)

14

während dieser Zeit innerhalb eines Toleranzbereichs konstant geblieben ist oder vernachlässigbar klein ist, so dass nun der Offsetanteil in dem Sensorausgangssignal bei diesem sehr hohen Versorgungssignalwert bestimmt werden kann. Die weiteren Messwerte, d. h. die Sensorausgangssignalwerte, bei dem hohen Versorgungssignalwert können nun um den ermittelten Offsetanteil korrigiert werden.

Die Annahme das der Offset während der Messungen konstant geblieben ist lässt sich z. B. dadurch überprüfen, dass zuerst eine Messung mit hoher Versorgungsspannung durchgeführt wird, anschließend mit niedriger Versorgungsspannung der Offset bestimmt wird und danach wieder mit hoher Offset-Spannung

Die im vorhergehenden beschriebenen Verfahren 100, 200 lassen sich auch anwenden, wenn der Hall-Sensor mit einem Versorgungsstrom als Versorgungssignal gespeist wird. Versorgungsspannung und Versorgungsstrom lassen sich mit Hilfe des Widerstandes des Hall-Sensors ineinander überführen.

Das vorliegende Konzept zur Offsetkompensation zeichnet sich also beispielsweise dadurch aus, dass der Offset eines Hall-Sensors im laufenden Betrieb näherungsweise bestimmt werden kann. Ein aufwändiger Serientest bei zum Teil verschiedenen Temperaturen zur Offset-Kompensation kann so vermieden werden.

Die Konzept ist auch sehr effektiv einsetzbar, wenn durch einen Spinning-Current Betrieb eines Hall-Sensors konstante und lineare Offsetanteile in der Hall-Spannung nahezu vollständig entfernt werden. Bei einer Auftragung der gemessenen Hall-Spannung über der Versorgungsspannung eines Hall-Elementes können damit lineare Anteile nur noch vom magnetischen Signal verursacht werden. Alle anderen Anteile (konstante, quadratische und höhere Ordnungen) können dann vom Signal separiert werden und müssen als Offset interpretiert werden. Damit ist rechnerisch eine Offset-Korrektur möglich.

Durch eine Modulation der Versorgungsspannung eines Hall-Elements (Hall-Sensors) lässt sich dessen Offsetanteil im Sensorausgangssignal auch mit einem externen Magnetfeld bestimmen, falls das externe Magnetfeld während der Bestimmung des Offsetanteils innerhalb eines Toleranzbereichs konstant ist.

Da das vorliegende Kompensationsverfahren 100, 200 noch ausreichend gute Kompensationsergebnisse liefert, wenn das externe Magnetfeld (d.h. die Magnetfeldstärke bzw. Flussdichte) innerhalb eines vorgegeben Bereichs bleibt oder kein oder nur eines vernachlässigbar kleines externes Magnetfeld vorhanden ist, wird ein sogenannter "Toleranzbereich" für die "geforderte Konstanz" des externen Magnetfelds eingeführt bzw. vorgesehen. Der Toleranzbereich gibt also den Bereich an, innerhalb dessen sich das externe Magnetfeld während der Bestimmung des Offsetanteils bzw. Rest-Offsetanteils ändern darf. Der Toleranzbereich kann beispielsweise angeben, dass sich das externe Magnetfeld während der Bestimmung des Offsetanteils bzw. Rest-Offsetanteils weniger als 50%, 30%, 20%, 10%, 5%, 1% oder 0,1% ändert oder kein oder nur ein vernachlässigbar kleines externes Magnetfeld vorhanden ist. Je niedriger der Toleranzbereich angenommen wird und eingehalten werden kann, umso genauer kann die Offsetkompensation durchgeführt werden. Falls eine mögliche oder typische Änderungsrate des externen Magnetfelds bekannt ist, kann ein Zeitintervall $\Delta t1$ für den Kompensationsvorgang so gewählt werden, dass die Offset-Messvorgänge zeitlich so (kurz) aufeinanderfolgend ausgeführt werden, dass während des Zeitintervalls $\Delta t1$ das auf dem Hall-Sensor einwirkende Messmagnetfeld innerhalb des (vorgegebenen) Toleranzbereichs konstant ist oder kein oder nur ein vernachlässigbar kleines externes Magnetfeld vorhanden ist.

Ausführungsbeispiele des vorliegende Kompensationsverfahren 100, 200 können also bei Änderungen der Temperatur durchgeführt werden. Dieser Ansatz ist sehr effektiv, da bei konstanter Temperatur der Offset in der Regel gleich bleibt und somit nicht ständig bestimmt werden muss.

Ausführungsbeispiele des vorliegende Kompensationsverfahren 100, 200 können auch bei weiteren, unterschiedliche Szenarien ausgeführt werden.

So kann das Kompensationsverfahren 100, 200 beispielsweise einmalig im Serientest durchgeführt werden, wobei dann aber in einem Serientest über Temperatur zu messen ist. So kann das Kompensationsverfahren 100, 200 beispielsweise dauernd im Betrieb durchgeführt werden. So kann das Kompensationsverfahren 100, 200 beispielsweise in bestimmten Intervallen durchgeführt werden.

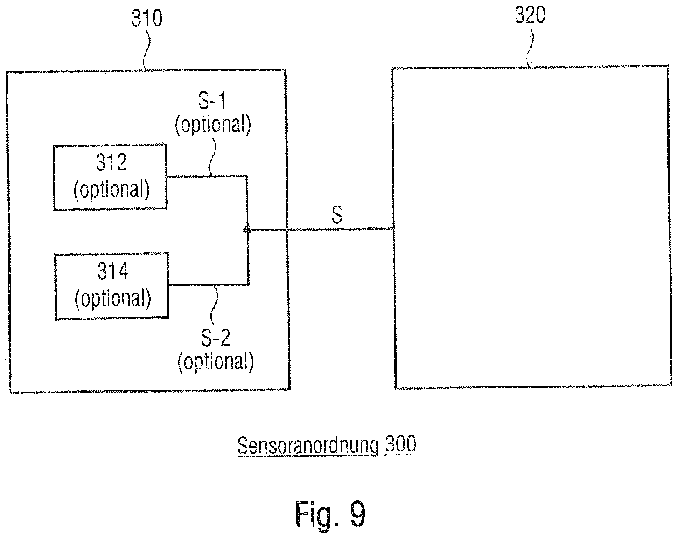

Fig. 9 zeigt nun ein beispielhaftes Blockdiagramm einer Sensoranordnung 300 mit einem Hall-Sensor 310 zum Erfassen einer Komponente eines Messmagnetfelds und zum Ausgeben eines auf der erfassten Komponente des Messmagnetfelds basierenden Sensorsignals S und einer Verarbeitungseinrichtung 320, die ausgebildet ist, um das im Vorhergehenden erläuterte Verfahren 100, 200 zur Offset-Kompensation eines Hall-Sensors durchzuführen.

Gemäß einem Ausführungsbeispiel kann der Hall-Sensor 310 ein beliebiges Halleffekt-Sensorelement, wie z.B. ein horizontales oder vertikales Halleffekt-Sensorelement, aufweisen. Der Hall-Sensor 310 kann beispielsweise ein Halleffekt-Sensorelement oder eine Mehrzahl von (z.B. verschalteten) Halleffekt-Sensorelementen aufweisen.

Gemäß einem Ausführungsbeispiel kann der Hall-Sensor 310 zumindest ein erstes Hall-Sensorelement 312 zum Bereitstellen eines ersten Hall-Sensorsignals S-1 und ein zweites Hall-Sensorelement (314) zum Bereitstellen eines zweiten Hall-Sensorsignals S-2 aufweisen. Dabei das Sensorsignal S auf einer Kombination des ersten und zweiten Hall-Sensorsignals (S-1, S-2) basieren. Ferner kann das Sensorsignal S auf einer Kombination eines ersten aufbereiteten Sensorsignal und einem zweiten aufbereiteten Sensorsignal, die von dem ersten und dem zweiten Hall-Sensorsignal abgeleitet sind, basieren.

Gemäß einem Ausführungsbeispiel kann der Hall-Sensor 310 zumindest ein erstes Hall-Sensorelement 312 zum Bereitstellen eines ersten Hall-Sensorsignals S-1 und ein zweites Hall-Sensorelement 314 zum Bereitstellen eines zweiten Hall-Sensorsignals S-2 aufweisen, wobei das Verfahren zur Offsetkompensation mit dem ersten Hall-Sensorsignal und mit dem zweiten Hall-Sensorsignal durchgeführt wird.

Gemäß einem Ausführungsbeispiel kann das erste Hall-Sensorelement 312 und das zweite Hall-Sensorelement 314 einen Winkelsensor oder einen Positionssensor bilden.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar. Einige oder alle der Verfahrensschritte können durch einen Hardware-Apparat, wie z.B. die Verarbeitungseinrichtung 320, (oder unter Verwendung eines solchen Hardware-Apparats), wie zum Beispiel einen Mikroprozessor, einen programmierbaren Computer oder einer elektronischen Schaltung durchgeführt werden. Bei einigen Ausführungsbeispielen können einige oder mehrere der wichtigsten Verfahrensschritte durch einen solchen Apparat ausgeführt werden.

Je nach bestimmten Implementierungsanforderungen können Ausführungsbeispiele der Erfindung in Hardware oder in Software oder zumindest teilweise in Hardware oder zumindest teilweise in Software implementiert sein. Die Implementierung kann unter Verwendung eines digitalen Speichermediums, beispielsweise einer Floppy-Disk, einer DVD, einer BluRay Disc, einer CD, eines ROM, eines PROM, eines EPROM, eines EEPROM oder eines FLASH-Speichers, einer Festplatte oder eines anderen magnetischen oder optischen Speichers durchgeführt werden, auf dem elektronisch lesbare Steuersignale gespeichert sind, die mit einem programmierbaren Computersystem derart zusammenwirken können oder zusammenwirken, dass das jeweilige Verfahren durchgeführt wird. Deshalb kann das digitale Speichermedium computerlesbar sein.

Manche Ausführungsbeispiele gemäß der Erfindung umfassen also einen Datenträger, der elektronisch lesbare Steuersignale aufweist, die in der Lage sind, mit einem programmierbaren Computersystem derart zusammenzuwirken, dass eines der hierin beschriebenen Verfahren durchgeführt wird.

Allgemein können Ausführungsbeispiele der vorliegenden Erfindung als Computerprogrammprodukt mit einem Programmcode implementiert sein, wobei der Programmcode dahin gehend wirksam ist, eines der Verfahren durchzuführen, wenn das Computerprogrammprodukt auf einem Computer abläuft.

Der Programmcode kann beispielsweise auch auf einem maschinenlesbaren Träger gespeichert sein.

Andere Ausführungsbeispiele umfassen das Computerprogramm zum Durchführen eines der hierin beschriebenen Verfahren, wobei das Computerprogramm auf einem maschinen-lesbaren Träger gespeichert ist. Mit anderen Worten ist ein Ausführungsbeispiel des erfindungsgemäßen Verfahrens somit ein Computerprogramm, das einen Programmcode zum Durchführen eines der hierin beschriebenen Verfahren aufweist, wenn das Computerprogramm auf einem Computer abläuft.

Ein weiteres Ausführungsbeispiel der erfindungsgemäßen Verfahren ist somit ein Datenträger (oder ein digitales Speichermedium oder ein computerlesbares Medium), auf dem das Computerprogramm zum Durchführen eines der hierin beschriebenen Verfahren aufgezeichnet ist. Der Datenträger oder das digitale Speichermedium oder das computerlesbare Medium sind typischerweise greifbar und/oder nicht flüchtig.

Ein weiteres Ausführungsbeispiel des erfindungsgemäßen Verfahrens ist somit ein Datenstrom oder eine Sequenz von Signalen, der bzw. die das Computerprogramm zum Durchführen eines der hierin beschriebenen Verfahren darstellt bzw. darstellen. Der Datenstrom oder die Sequenz von Signalen kann bzw. können beispielsweise dahin gehend konfiguriert sein, über eine Datenkommunikationsverbindung, beispielsweise über das Internet, transferiert zu werden.

Ein weiteres Ausführungsbeispiel umfasst eine Verarbeitungseinrichtung, beispielsweise einen Computer oder ein programmierbares Logikbauelement, die dahin gehend konfiguriert oder angepasst ist, eines der hierin beschriebenen Verfahren durchzuführen.

Ein weiteres Ausführungsbeispiel umfasst einen Computer, auf dem das Computerprogramm zum Durchführen eines der hierin beschriebenen Verfahren installiert ist.

Ein weiteres Ausführungsbeispiel gemäß der Erfindung umfasst eine Vorrichtung oder ein System, die bzw. das ausgelegt ist, um ein Computerprogramm zur Durchführung zumindest eines der hierin beschriebenen Verfahren zu einem Empfänger zu übertragen. Die Übertragung kann beispielsweise elektronisch oder optisch erfolgen. Der Empfänger kann beispielsweise ein Computer, ein Mobilgerät, ein Speichergerät oder eine ähnliche Vorrichtung sein. Die Vorrichtung oder das System kann beispielsweise einen Datei-Server zur Übertragung des Computerprogramms zu dem Empfänger umfassen.

Bei manchen Ausführungsbeispielen kann ein programmierbares Logikbauelement (beispielsweise ein feldprogrammierbares Gatterarray, ein FPGA) dazu verwendet werden, manche oder alle Funktionalitäten der hierin beschriebenen Verfahren durchzuführen. Bei manchen Ausführungsbeispielen kann ein feldprogrammierbares Gatterarray mit einem Mikroprozessor zusammenwirken, um eines der hierin beschriebenen Verfahren durchzuführen. Allgemein werden die Verfahren bei einigen Ausführungsbeispielen seitens einer beliebigen Hardwarevorrichtung durchgeführt. Diese kann eine universell einsetzbare Hardware wie ein Computerprozessor (CPU) sein oder für das Verfahren spezifische Hardware, wie beispielsweise ein ASIC.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1.   Verfahren (100) zur Offsetkompensation eines Sensorsignals $S_0$ eines Hall-Sensor, mit folgenden Schritten:

Durchführen (110) einer ersten Offsetkompensation an dem Sensorsignal $S_0$ zum Bereitstellen eines vorkompensierten Sensorsignals S, wobei bei der ersten Offsetkompensation ein in Bezug auf ein Versorgungssignal $S_{DD}$ linearer Anteil des Offsets in dem Sensorsignal zumindest reduziert wird,
Ermitteln (120) einer Vielzahl N, mit $N \geqq 3$, von Sensorsignalwerten $S_N$ bei unterschiedlichen Offset-Messvorgängen und mit unterschiedlichen Versorgungssignalwerten $S_{DDN}$ innerhalb eines Zeitintervalls $\Delta t1$, wobei die Offset-Messvorgänge zeitlich so aufeinander folgend ausgeführt werden, dass während des Zeitintervalls $\Delta t1$ das auf den Hall-Sensor einwirkende Messmagnetfeld innerhalb eines Toleranzbereiches konstant ist,
Bestimmen (130) einer Fitting-Funktion $F(S_{DD})$ für das vorkompensierte Sensorsignal über dem Versorgungssignal $S_{DD}$ basierend auf den ermittelten N Sensorsignalwerten $S_N$, mit

$$F(S_{DD}) = \text{Konstanter Anteil} + \text{Linearer Anteil} + \text{Nicht-linearer Anteil}$$

wobei der nichtlineare Anteil der Fitting-Funktion auf einem Rest-Offsetanteil R in dem vorkompensierten Sensorsignal S basiert, und

(1) wobei der lineare Anteil der Fitting-Funktion auf dem Messmagnetfeld basiert, wenn das vorkompensierten Sensorsignal proportional zu einer erfassten Hall-Spannung des Hall-Sensors ist; und
(2) wobei der konstante Anteil der Fitting-Funktion auf dem Messmagnetfeld basiert, wenn das vorkompensierten Sensorsignal proportional zu dem einwirkenden Messmagnetfeld ist, das basierend auf der erfassten Hall-Spannung und der Empfindlichkeit des Hall-Sensors ermittelt wird;

Berechnen (140) eines Offset-reduzierten Sensorsignalwerts $S_0$ basierend auf dem Anteil der ermittelten Fitting-Funktion, der auf dem Messmagnetfeld basiert,
Erfassen (150) eines Sensorsignalwerts $S_N$ bei einem Versorgungssignalwert $S_{DDN}$;
Ermitteln (160) des Rest-Offsetanteils R des vorkompensierten Sensorsignals S bei dem Versorgungssignalwert $S_{DDN}$ als Differenz zwischen dem Sensorsignalwert $S_N$ und dem Offset-reduzierten Sensorsignalwert $S_0$; und
Durchführen (170) einer Offsetkompensation an dem Sensorsignal S basierend auf dem ermittelten Offsetanteil R bei dem Versorgungssignalwert $S_{DDN}$.

2.   Verfahren (100) nach Anspruch 1, ferner mit folgendem Schritt:
Erfassen einer momentanen Temperatur $T_0$ an dem Hall-Sensor, wobei die Schritte des Ermittelns des Rest-Offsetanteils und des Durchführens der zweiten Offset-kompensation wiederholt werden, wenn eine Änderung der momentanen Temperatur $T_0$ zu einer vorhergehend durchgeführten Offsetkompensation von zumindest 2°C erfasst wird.

3.   Verfahren (100) nach einem der vorhergehenden Ansprüche, wobei die erste Offsetkompensation mittels eines Spinning-Current-Verfahrens durch geführt wird, um das vorkompensierte Sensorsignal zu erhalten.

4.   Verfahren (100) nach Anspruch 3, ferner mit folgendem Schritt:
Durchführen eines Verfahrens zur orthogonalen Paarbildung und/oder eines Verfahrens zur Zwangssymmetrierung bei der ersten Offsetkompensation.

5. Verfahren (100) nach einem der vorhergehenden Ansprüche, ferner mit folgendem Schritt:
Durchführen eines Funktionstests dem Hall-Sensor und einer nachgeschalteten Sensorsignal-Auswerteschaltung im Betrieb mittels einer Plausibilitätsüberprüfung des ermittelten Rest-Offsetanteils R in dem vorkompensierten Sensorsignal S des Hall-Sensors.

6. Verfahren (100) nach einem der vorhergehenden Ansprüche, wobei die Schritte des Ermittelns (120) des Rest-Offsetanteils R und des Durchführens (170) der Offsetkompensation in vorgegebenen, zeitlich beabstandeten Zeitintervallen während des Betriebs des Hall-Sensors durchgeführt werden.

7. Verfahren (100) nach einem der Ansprüche 1 bis 5, wobei die Schritte des Ermittelns des Rest-Offsetanteils und des Durchführens der zweiten Offsetkompensation kontinuierlich im Betrieb des Hall-Sensors durchgeführt werden.

8. Verfahren (100) nach einem der vorhergehenden Ansprüche, wobei ein Versorgungssignal $S_{DD}$ zum Bereitstellen der Versorgungssignalwerte $S_{DD1}$, $S_{DD2}$ als eine Versorgungsspannung oder ein Versorgungsstrom in den Hall-Sensor eigespeist wird.

9. Verfahren (100) nach einem der vorhergehenden Ansprüche, wobei der Hall-Sensor zumindest ein ersten Hall-Sensorelement zum Bereitstellen eines ersten Hall-Sensorsignals und ein zweites Hall-Sensorelement zum Bereitstellen eines zweiten Hall-Sensorsignals aufweist,

   wobei das Sensorsignal auf einer Kombination des ersten und zweiten Hall-Sensorsignals basiert,
   oder
   wobei das Sensorsignal auf einer Kombination eines ersten aufbereiteten Sensorsignals und einem zweiten aufbereiteten Sensorsignals, die von dem ersten und dem zweiten Hall-Sensorsignal abgeleitet sind, basiert.

10. Verfahren (100) nach Anspruch 9, wobei das erste Hall-Sensorelement und das zweite Hall-Sensorelement einen Winkelsensor oder einen Positionssensor bilden.

11. Verfahren (200) zur Offsetkompensation eines Sensorsignals S eines Hall-Sensors, mit folgenden Schritten:

   Ermitteln (210) eines ersten Sensorsignalwerts S1 des Sensorsignals S bei einem ersten Offsetmessvorgang basierend auf einem ersten Versorgungssignalwert $S_{DD1}$ und eines zweiten Sensorsignalwerts S2 des Sensorsignals bei einem zweiten Offsetmessvorgang basierend auf einem zweiten Versorgungssignalwert $S_{DD2}$,

   wobei der erste Versorgungssignalwert $S_{DD1}$ so gewählt ist, dass ein Rest-Offsetanteil R1 in dem ersten Sensorsignalwert S1 weniger als 50% des ersten Sensorsignalwerts S1 beträgt, und
   wobei der erste und der zweite Offset-Messvorgang zeitlich so aufeinander folgend ausgeführt werden, dass bei dem ersten und zweiten Offsetmessvorgang das auf den Hall-Sensor einwirkende Messmagnetfeld innerhalb eines Toleranzbereiches konstant ist, und

   Ermitteln (220) eines Offsetanteils R2 in dem Sensorsignal S für den zweiten Versorgungssignalwert $S_{DD2}$ als Differenz zwischen dem zweiten Sensorsignalwert $S_{DD2}$ und dem ersten Sensorsignalwert $S_{DD1}$; und
   Durchführen (230) einer Offsetkompensation an dem Sensorsignal S basierend auf dem ermittelten Offsetanteil R bei dem zweiten Versorgungssignalwert $S_{DD2}$,
   wobei die Schritte des Ermittelns des Rest-Offsetanteils und des Durchführens der zweiten Offsetkompensation im Betrieb des Hall-Sensors durchgeführt werden.

12. Verfahren (200) nach Anspruch 11, wobei bei dem Schritt des Ermittelns des ersten Sensorsignalwerts S1 der erste Versorgungssignalwert $S_{DD1}$ um einen Faktor von zumindest 2 kleiner als der zweite Versorgungssignalwert $S_{DD2}$ gewählt wird.

13. Verfahren (200) nach einem der Ansprüche 11 oder 12, ferner mit folgendem Schritt:
Erfassen einer momentanen Temperatur $T_0$ an dem Hall-Sensor, wobei die Schritte des Ermittelns des Rest-Offsetanteils R1 und des Durchführens einer zweiten Offsetkompensation wiederholt werden, wenn eine Änderung der momentanen Temperatur $T_0$ von zumindest 2°C zu einer vorhergehend durgeführten zweiten Offsetkompensation erfasst wird.

**14.** Verfahren (200) nach einem der Ansprüche 11 bis 13, wobei der erste Sensorsignalwert S1 bei dem ersten Offsetmessvorgang und der zweite Sensorsignalwert S2 bei dem zweiten Offsetmessvorgang innerhalb eines Offset-Messzeitintervalls $\Delta t1$ bereitgestellt werden, ferner mit folgendem Schritt:
Bereitstellen eines Test-Sensorsignalwerts TS1 mit dem ersten Versorgungssignalwert $S_{DD1}$ innerhalb des Mess-Zeitintervalls $\Delta t1$ nach dem ersten und zweiten Offsetmessvorgang, wobei eine Übereinstimmung (innerhalb eines Toleranzbereichs) des ersten Sensorsignalwerts S1 und des Test-Sensorsignalwerts TS1 das Vorliegen einer konstanten Temperatur und eines konstanten einwirkenden Messmagnetfelds während des Messintervalls $\Delta t1$ angibt.

**15.** Verfahren (200) nach einem der Ansprüche 11 bis 14, ferner mit folgendem Schritt:

Durchführen einer Offset-Vorkompensation an dem Sensorsignal S vor dem Schritt des Ermittelns des ersten und zweiten Sensorsignalwerts S1, S2,
wobei die Offset-Vorkompensation mittels eines Spinning-Current-Verfahrens oder mittels eines Verfahrens zur orthogonalen Paarbildung und/oder mittels eines Verfahrens zur Zwangssymmetrierung durchgeführt wird, um ein vorkompensiertes Sensorsignal S zu erhalten.

**16.** Verfahren (200) nach einem der Ansprüche 11 bis 15, ferner mit folgendem Schritt:
Durchführen (200) eines Funktionstests an dem Hall-Sensor und einer nachgeschalteten Sensorsignal-Auswerteschaltung im Betrieb mittels einer Plausibilitätsüberprüfung des ermittelten Offsetanteils R in dem Sensorsignal S des Hall-Sensors.

**17.** Verfahren (200) nach einem der Ansprüche 11 bis 16, wobei die Schritte des Ermittelns des Rest-Offsetanteils R1 und des Durchführens der zweiten Offsetkompensation in vorgegebenen, zeitlich beabstandeten Zeitintervallen während des Betriebs des Hall-Sensors durchgeführt werden.

**18.** Verfahren (200) nach einem der Ansprüche 11 bis 17, wobei das Versorgungssignal $S_{DD}$ zum Bereitstellen Versorgungssignalwerte $S_{DD1}$, $S_{DD2}$ als eine Versorgungsspannung oder ein Versorgungsstrom in den Hall-Sensor eigespeist wird.

**19.** Verfahren (200) nach einem der Ansprüche 11 bis 18, wobei der Hall-Sensor zumindest ein erstes Hall-Sensorelement zum Bereitstellen eines ersten Hall-Sensorsignals und ein zweites Hall-Sensorelement zum Bereitstellen eines zweiten Hall-Sensorsignals aufweist,

wobei das Sensorsignal auf einer Kombination des ersten und zweiten Hall-Sensorsignals basiert,
oder
wobei das Sensorsignal auf einer Kombination eines ersten aufbereiteten Sensorsignals und s zweiten aufbereiteten Sensorsignals, die von dem ersten und dem zweiten Hall-Sensorsignal abgeleitet sind, basiert.

**20.** Verfahren (200) nach Anspruch 19, wobei das erste Hall-Sensorelement und das zweite Hall-Sensorelement einen Winkelsensor oder einen Positionssensor bilden.

**21.** Sensoranordnung (300) mit folgenden Merkmalen:

Einem Hall-Sensor (310) zum Erfassen einer Komponente eines Messmagnetfelds und zum Ausgeben eines auf der erfassten Komponente des Messmagnetfelds basierenden Sensorsignals S, und
einer Verarbeitungseinrichtung (320), die ausgebildet ist, um das Verfahren zur Offsetkompensation eines Hall-Sensors (310) gemäß einem der vorhergehenden Ansprüche auszuführen.

**22.** Sensoranordnung (300) nach Anspruch 21, wobei der Hall-Sensor (310) ein horizontales oder vertikales Halleffekt-Sensorelement aufweist.

**23.** Sensoranordnung (300) nach Anspruch 21 oder 22, wobei der Hall-Sensor (310) zumindest ein erstes Hall-Sensorelement (312) zum Bereitstellen eines ersten Hall-Sensorsignals (S-1) und ein zweites Hall-Sensorelement (314) zum Bereitstellen eines zweiten Hall-Sensorsignals (S-2) aufweist,

wobei das Sensorsignal S auf einer Kombination des ersten und zweiten Hall-Sensorsignals (S-1, S-2) basiert,
oder
wobei das Sensorsignal S auf einer Kombination eines ersten aufbereiteten Sensorsignal und einem zweiten aufbereiteten Sensorsignal, die von dem ersten und dem zweiten Hall-Sensorsignal abgeleitet sind, basiert.

**24.** Sensoranordnung (300) nach Anspruch 21 oder 22, wobei der Hall-Sensor (310) zumindest ein erstes Hall-Sensorelement (312) zum Bereitstellen eines ersten Hall-Sensorsignals (S-1) und ein zweites Hall-Sensorelement (314) zum Bereitstellen eines zweiten Hall-Sensorsignals (S-2) aufweist,
wobei das Verfahren zur Offsetkompensation mit dem ersten Hall-Sensorsignal und mit dem zweiten Hall-Sensorsignal durchgeführt wird.

**25.** Sensoranordnung (300) nach Anspruch 23 oder 24, wobei das erste Hall-Sensorelement (312) und das zweite Hall-Sensorelement (314) einen Winkelsensor oder einen Positionssensor bilden.

**Claims**

**1.** A method (100) for offset compensation of a sensor signal $S_0$ of a Hall sensor, comprising the steps of:

performing (110) a first offset compensation of the sensor signal $S_0$ for providing a pre-compensated sensor signal S, wherein a portion of the offset, linear relative to a supply signal $S_{DD}$, in the sensor signal is at least reduced in the first offset compensation,
establishing (120) a plurality of N, with $N \geq 3$, sensor signal values $S_N$ in different offset measuring processes and with different supply signal values $S_{DDN}$ within a time interval $\Delta t1$, wherein the offset measuring processes are executed in a temporal succession such that the measuring magnetic field acting on the Hall sensor is constant within a tolerance range during the time interval $\Delta t1$,
determining (130) a fitting function $F(S_{DD})$ for the pre-compensated sensor signal versus the supply signal $S_{DD}$ based on the established N sensor signal values $S_N$, with

$$F(S_{DD}) = \text{constant portion} + \text{linear portion} + \text{non-linear portion}$$

wherein the non-linear portion of the fitting function is based on a residual offset portion R in the pre-compensated sensor signal S, and

(1) wherein the linear portion of the fitting function is based on the measuring magnetic field when the pre-compensated sensor signal is proportional to a detected Hall voltage of the Hall sensors; and
(2) wherein the constant portion of the fitting function is based on the measuring magnetic field when the pre-compensated sensor signal is proportional to the measuring magnetic field acting which is established based on the detected Hall voltage and the sensitivity of the Hall sensor;

calculating (140) an offset-reduced sensor signal value $S_0$ based on the portion of the established fitting function which is based on the measuring magnetic field;
detecting (150) a sensor signal value $S_N$ at a supply signal value $S_{DDN}$;
establishing (160) the residual offset portion R of the pre-compensated sensor signal S at the supply signal value $S_{DDN}$ as the difference between the sensor signal value $S_N$ and the offset-reduced sensor signal value $S_0$; and
performing (170) an offset compensation of the sensor signal S based on the established offset portion R at the supply signal value $S_{DDN}$.

**2.** The method (100) in accordance with claim 1, further comprising the step of:
detecting a current temperature $T_0$ at the Hall sensor, wherein the steps of establishing the residual offset portion and of performing the second offset compensation are repeated when detecting a change in the current temperature $T_0$ of at least 2°C relative to a previously performed offset compensation.

**3.** The method (100) in accordance with any of the preceding claims, wherein the first offset compensation is performed by means of a spinning-current method in order to obtain the pre-compensated sensor signal.

**4.** The method (100) in accordance with claim 3, further comprising the step of:
performing a method of orthogonal pair formation and/or a forced symmetry method in the first offset compensation.

**5.** The method (100) in accordance with any of the preceding claims, further comprising the step of:
performing a functional test of the Hall sensor and a downstream sensor signal evaluating circuit during operation by means of a plausibility check of the established residual offset portion R in the pre-compensated sensor signal S of the Hall sensor.

**6.** The method (100) in accordance with any of the preceding claims, wherein the steps of establishing (120) the residual offset portion R and of performing (170) the offset compensation are performed in predetermined time intervals spaced apart in time during operation of the Hall sensor.

**7.** The method (100) in accordance with any of claims 1 to 5, wherein the steps of establishing the residual offset portion and of performing the second offset compensation are performed continuously during operation of the Hall sensor.

**8.** The method (100) in accordance with any of the preceding claims, wherein a supply signal $S_{DD}$ for providing the supply signal values $S_{DD1}$, $S_{DD2}$ is fed to the Hall sensor as a supply voltage or a supply current.

**9.** The method (100) in accordance with any of the preceding claims, wherein the Hall sensor comprises at least a first Hall sensor element for providing a fist Hall sensor signal and a second Hall sensor element for providing a second Hall sensor signal,

wherein the sensor signal is based on a combination of the first and second Hall sensor signals,
or
wherein the sensor signal is based on a combination of a first rendered sensor signal and a second rendered sensor signal derived from the first and second Hall sensor signals.

**10.** The method (100) in accordance with claim 9, wherein the first Hall sensor element and the second Hall sensor element form an angle sensor or a position sensor.

**11.** A method (200) for offset compensation of a sensor signal S of a Hall sensor, comprising the steps of:

establishing (210) a first sensor signal value S1 of the sensor signal S in a first offset measuring process based on a first supply signal value $S_{DD1}$ and a second sensor signal value S2 of the sensor signal in a second offset measuring process based on a second supply signal value $S_{DD2}$,

wherein the first supply signal value $S_{DD1}$ is selected such that a residual offset portion R1 in the first sensor signal value S1 is less than 50% of the first sensor signal value S1, and
wherein the first and second offset measuring processes are executed in a temporal succession such that the measuring magnetic field acting on the Hall sensor is constant within a tolerance range in the first and second offset measuring processes;

establishing (220) an offset portion R2 in the sensor signal S for the second supply signal value $S_{DD2}$ as the difference between the second sensor signal value $S_{DD2}$ and the first sensor signal value $S_{DD1}$; and
performing (230) an offset compensation of the sensor signal S based on the established offset portion R at the second supply signal value $S_{DD2}$,
wherein the steps of establishing the residual offset portion and of performing the second offset compensation are performed during operation of the Hall sensor.

**12.** The method (200) in accordance with claim 11, wherein, in the step of establishing the first sensor signal value S1, the first supply signal value $S_{DD1}$ is selected to be smaller by a factor of at least 2 than the second supply signal value $S_{DD2}$.

**13.** The method (200) in accordance with any of claims 11 or 12, further comprising the step of:
detecting a current temperature $T_0$ at the Hall sensor, wherein the steps of establishing the residual offset portion R1 and of performing a second offset combination are repeated when detecting a change in the current temperature $T_0$ of at least 2°C relative to a previously performed second offset compensation.

**14.** The method (200) in accordance with any of claims 11 to 13, wherein the first sensor signal value S1 is provided in the first offset measuring process and the second sensor signal value S2 is provided in the second offset measuring process within an offset measuring time interval $\Delta t1$, further comprising the step of:
providing a test sensor signal value TS1 at the first supply signal value $S_{DD1}$ within the measuring time interval $\Delta t1$ after the first and second offset measuring processes, wherein a match (within a tolerance range) of the first sensor signal value S1 and the test sensor signal value TS1 indicates the presence of a constant temperature and a constant measuring magnetic field acting during the measuring time interval $\Delta t1$.

15. The method (200) in accordance with any of claims 11 to 14, further comprising the step of:

performing an offset pre-compensation of the sensor signal S before the step of establishing the first and second sensor signal values S1, S2, wherein the offset pre-compensation is performed by means of a spinning-current method or by means of a method for orthogonal pair formation and/or by means of a forced symmetry method, in order to obtain a pre-compensated sensor signal S.

16. The method (200) in accordance with any of claims 11 to 15, further comprising the step of:
performing (200) a functional test of the Hall sensor and a downstream sensor signal evaluating circuit during operation by means of a plausibility check of the established offset portion R in the sensor signal S of the Hall sensor.

17. The method (200) in accordance with any of claims 11 to 16, wherein the steps of establishing the residual offset portion R1 and of performing the second offset compensation are performed in predetermined time intervals spaced apart in time during operation of the Hall sensor.

18. The method (200) in accordance with any of claims 11 to 17, wherein the supply signal $S_{DD}$ for providing supply signal values $S_{DD1}$, $S_{DD2}$ is fed to the Hall sensor as a supply voltage or a supply current.

19. The method (200) in accordance with any of claims 11 to 18, wherein the Hall sensor comprises at least a first Hall sensor element for providing a first Hall sensor signal and a second Hall sensor element for providing a second Hall sensor signal,

wherein the sensor signal is based on a combination of the first and second Hall sensor signals, or
wherein the sensor signal is based on a combination of a first rendered sensor signal and a second rendered sensor signal derived from the first and second Hall sensor signals.

20. The method (200) in accordance with claim 19, wherein the first Hall sensor element and the second Hall sensor element form an angle sensor or position sensor.

21. A sensor arrangement (300) comprising:

a Hall sensor (310) for detecting a component of a measuring magnetic field and for outputting a sensor signal S based on the detected component of the measuring magnetic field, and
processing means (320) configured to execute the method for offset compensation of a Hall sensor (310) in accordance with any of the preceding claims.

22. The sensor arrangement (300) in accordance with claim 21, wherein the Hall sensor (310) comprises a horizontal or a vertical Hall effect sensor element.

23. The sensor arrangement (300) in accordance with claim 21 or 22, wherein the Hall sensor (310) comprises at least a first Hall sensor element (312) for providing a first Hall sensor signal (S-1) and a second Hall sensor element (314) for providing a second Hall sensor signal (S-2),

wherein the sensor signal S is based on a combination of the first and second Hall sensor signals (S-1, S-2), or
wherein the sensor signal is based on a combination of a first rendered sensor signal and a second rendered sensor signal derived from the first and second Hall sensor signals.

24. The sensor arrangement (300) in accordance with claim 21 or 22, wherein the Hall sensor (310) comprises at least a first Hall sensor element (312) for providing a first Hall sensor signal (S-1) and a second Hall sensor element (314) for providing a second Hall sensor signal (S-2),
wherein the method for offset compensation is performed using the first Hall sensor signal and using the second Hall sensor signal.

**25.** The sensor arrangement (300) in accordance with claim 23 or 24, wherein the first Hall sensor element (312) and the second Hall sensor element (314) form an angle sensor or position sensor.

**Revendications**

**1.** Procédé (100) de compensation de décalage d'un signal de capteur So d'un capteur à effet Hall, aux étapes suivantes consistant à:

effectuer (110) une première compensation de décalage sur le signal de capteur $S_0$ pour fournir un signal de capteur pré-compensé S, où lors de la première compensation de décalage est au moins réduite, par rapport à un signal d'alimentation $S_{DD}$, une part linéaire du décalage dans le signal de capteur,
déterminer (120) une pluralité N, où $N \geqq 3$, de valeurs de signal de capteur $S_N$ lors de différentes opérations de mesure de décalage et à différentes valeurs de signal d'alimentation $S_{DDN}$ dans un intervalle de temps $\Delta t1$, où les opérations de mesure de décalage sont effectuées de manière successive dans le temps de sorte que, pendant l'intervalle de temps $\Delta t1$, le champ magnétique de mesure agissant sur le capteur à effet Hall soit constant dans les limites d'une plage de tolérances,
déterminer (130) une fonction d'adaptation $F(S_{DD})$ pour le signal de capteur pré-compensé au-dessus du signal d'alimentation $S_{DD}$ sur base des N valeurs de signal de capteur $S_N$ déterminées, où

$$F(S_{DD}) = \text{part constante} + \text{part linéaire} + \text{part non linéaire}$$

où la part non linéaire de la fonction d'adaptation est basée sur une part de décalage résiduelle R dans le signal de capteur pré-compensé S, et

(1) où la part linéaire de la fonction d'adaptation est basée sur le champ magnétique de mesure lorsque le signal de capteur pré-compensé est proportionnel à une tension de Hall détectée du capteur à effet Hall; et
(2) où la part constante de la fonction d'adaptation est - basée sur le champ magnétique de mesure lorsque le signal de capteur pré-compensé est proportionnel au champ magnétique de mesure agissant qui est déterminé sur base de la tension de Hall détectée et de la sensibilité du capteur à effet Hall;

calculer (140) une valeur de signal de capteur à décalage réduit $S_0$ sur base de la part de la fonction d'adaptation déterminée qui se base sur le champ magnétique de mesure,
détecter (150) une valeur de signal de capteur $S_N$ à une valeur de signal d'alimentation $S_{DNN}$;
déterminer (160) la part de décalage résiduelle R du signal de capteur pré-compensé S à la valeur de signal d'alimentation $S_{DDN}$ comme différence entre la valeur de signal de capteur $S_N$ et la valeur de signal de capteur à décalage réduit $S_0$; et
effectuer (170) une compensation de décalage sur le signal de capteur S sur base de la part de décalage R déterminée à la valeur de signal d'alimentation $S_{DDN}$.

**2.** Procédé (100) selon la revendication 1, par ailleurs à l'étape suivante consistant à:
détecter une température momentanée $T_0$ au capteur à effet Hall, où les étapes de détermination de la part de décalage résiduelle et de réalisation de la deuxième compensation de décalage sont répétées lorsqu'est détectée une variation de la température momentanée $T_0$ d'au moins 2°C par rapport à une compensation de décalage effectuée auparavant.

**3.** Procédé (100) selon l'une des revendications précédentes, dans lequel la première compensation de décalage est effectuée au moyen d'un procédé à courant tournant pour obtenir le signal de capteur pré-compensé.

**4.** Procédé (100) selon la revendication 3, par ailleurs à l'étape suivante consistant à:
réaliser un procédé de formation de pair orthogonale et/ou un procédé d'équilibrage de symétrie forcé lors de la première compensation de décalage.

**5.** Procédé (100) selon l'une des revendications précédentes, par ailleurs à l'étape suivante consistant à:
effectuer un test de fonctionnement sur le capteur à effet Hall et sur un circuit d'évaluation du signal du capteur connecté en aval en fonctionnement au moyen d'un contrôle de plausibilité de la part de décalage résiduelle R déterminée dans le signal de capteur pré-compensé S du capteur à effet Hall.

**6.** Procédé (100) selon l'une des revendications précédentes, dans lequel les étapes consistant à déterminer (120) la part de décalage résiduelle R et à effectuer (170) la compensation de décalage sont effectuées à des intervalles de temps distants dans le temps pendant le fonctionnement du capteur à effet Hall.

**7.** Procédé (100) selon l'une des revendications 1 à 5, dans lequel les étapes consistant à déterminer la part de décalage résiduelle et à effectuer la deuxième compensation de décalage sont effectuées de manière continue pendant le fonctionnement du capteur à effet Hall.

**8.** Procédé (100) selon l'une des revendications précédentes, dans lequel un signal d'alimentation $S_{DD}$ destiné à fournir les valeurs de signal d'alimentation $S_{DD1}$, $S_{DD2}$ est alimenté sous forme d'une tension d'alimentation ou d'un courant d'alimentation vers le capteur à effet Hall.

**9.** Procédé (100) selon l'une des revendications précédentes, dans lequel le capteur à effet Hall présente au moins un premier élément de capteur à effet Hall destiné à fournir un premier signal de capteur à effet Hall et un deuxième élément de capteur à effet Hall destiné à fournir un deuxième signal de capteur à effet Hall,

dans lequel le signal de capteur est basé sur une combinaison du premier et du deuxième signal de capteur à effet Hall,
ou
dans lequel le signal de capteur est basé sur une combinaison d'un premier signal de capteur préparé et d'un deuxième signal de capteur préparé qui sont dérivés du premier et du deuxième signal de capteur à effet Hall.

**10.** Procédé (100) selon la revendication 9, dans lequel le premier élément de capteur à effet Hall et le deuxième élément de capteur à effet Hall constituent un capteur d'angle ou un capteur de position.

**11.** Procédé (200) de compensation de décalage d'un signal de capteur S d'un capteur à effet Hall, aux étapes suivantes consistant à:

déterminer (210) une première valeur de signal de capteur S1 du signal de capteur S lors d'une première opération de mesure de décalage sur base d'une première valeur de signal d'alimentation $S_{DD1}$ et une deuxième valeur de signal de capteur S2 du signal de capteur lors d'une deuxième opération de mesure de décalage sur base d'une deuxième valeur de signal d'alimentation $S_{DD2}$,

où la première valeur de signal d'alimentation $S_{DD1}$ est choisie de sorte qu'une part de décalage résiduelle R1 dans la première valeur de signal de capteur S1 soit inférieure à 50% de la première valeur de signal de capteur S1, et
où la première et la deuxième opération de mesure de décalage sont effectuées successivement dans le temps de sorte que, lors de la première et de la deuxième opération de mesure de décalage, le champ magnétique de mesure agissant sur le capteur à effet Hall soit constant dans les limites d'une plage de tolérances, et

déterminer (220) une part de décalage R2 dans le signal de capteur S pour la deuxième valeur de signal d'alimentation $S_{DD2}$ comme différence entre la deuxième valeur de signal de capteur $S_{DD2}$ et la première valeur de signal de capteur $S_{DD1}$; et
effectuer (230) une compensation de décalage sur le signal de capteur S sur base de la part de décalage R déterminée à la deuxième valeur de signal d'alimentation $S_{DD2}$,
dans lequel les étapes de détermination de la part de décalage résiduelle et de réalisation de la deuxième compensation de décalage sont effectuées pendant le fonctionnement du capteur à effet Hall.

**12.** Procédé (200) selon la revendication 11, dans lequel, à l'étape de détermination de la première valeur de signal de capteur S1, la première valeur de signal d'alimentation $S_{DD1}$ est choisie d'un facteur d'au moins 2 plus petit que le deuxième signal d'alimentation $S_{DD2}$.

**13.** Procédé (200) selon l'une des revendications 11 ou 12, par ailleurs à l'étape suivante consistant à:
détecter une température momentanée To au capteur Hall, où les étapes de détermination de la part de décalage résiduelle R1 et de réalisation d'une deuxième compensation de décalage sont répétées lorsqu'est détectée une variation de la température momentanée To d'au moins 2°C par rapport à une deuxième compensation de décalage effectuée auparavant.

**14.** Procédé (200) selon l'une des revendications 11 à 13, dans lequel la première valeur de signal de capteur S1 lors de la première opération de mesure de décalage et la deuxième valeur de signal de capteur S2 lors de la deuxième opération de mesure de décalage sont fournies dans un intervalle de temps de mesure de décalage $\Delta t1$, par ailleurs à l'étape suivante consistant à:
fournir une valeur de signal de capteur de test TS1 avec la première valeur de signal d'alimentation $S_{DD1}$ dans l'intervalle de temps de mesure $\Delta t1$ après la première et la deuxième opération de mesure de décalage, où une correspondance (dans les limites d'une plage de tolérances) de la première valeur de signal de capteur S1 et de la valeur de signal de capteur de test TS1 indique la présence d'une température constante et d'un champ magnétique de mesure agissant de manière constante pendant l'intervalle de mesure $\Delta t1$.

**15.** Procédé (200) selon l'une des revendications 11 à 14, par ailleurs à l'étape suivante consistant à:

effectuer une pré-compensation de décalage sur le signal de capteur S avant l'étape de détermination de la première et de la deuxième valeur de signal de capteur S1, S2,
dans lequel la pré-compensation de décalage est effectuée au moyen d'un procédé à courant tournant ou au moyen d'un procédé formation de pair orthogonale et/ou au moyen d'un procédé d'équilibrage de symétrie forcé, pour obtenir un signal de capteur pré-compensé S.

**16.** Procédé (200) selon l'une des revendications 11 à 15, par ailleurs à l'étape suivante consistant à:
effectuer (200) un test de fonctionnement sur le capteur à effet Hall et sur un circuit d'évaluation de signal de capteur connecté en aval en fonctionnement au moyen d'un contrôle de plausibilité de la part de décalage R déterminée dans le signal de capteur S du capteur à effet Hall.

**17.** Procédé (200) selon l'une des revendications 11 à 16, dans lequel les étapes consistant à déterminer la part de décalage résiduelle R1 et à effectuer la deuxième compensation de décalage sont effectuées à des intervalles de temps distants dans le temps pendant le fonctionnement du capteur à effet Hall.

**18.** Procédé (200) selon l'une des revendications 11 à 17, dans lequel le signal d'alimentation $S_{DD}$ destiné à fournir les valeurs de signal d'alimentation $S_{DD1}$, $S_{DD2}$ est alimenté sous forme d'une tension d'alimentation ou d'un courant d'alimentation vers le capteur à effet Hall.

**19.** Procédé (200) selon l'une des revendications 11 à 18, dans lequel le capteur à effet Hall présente au moins un premier élément de capteur à effet Hall destiné à fournir un premier signal de capteur à effet Hall et un deuxième élément de capteur à effet Hall destiné à fournir un deuxième signal de capteur à effet Hall,

dans lequel le signal de capteur est basé sur une combinaison du premier et du deuxième signal de capteur à effet Hall,
ou
dans lequel le signal de capteur est basé sur une combinaison d'un premier signal de capteur préparé et d'un deuxième signal de capteur préparé qui sont dérivés du premier et du deuxième signal de capteur à effet Hall.

**20.** Procédé (200) selon la revendication 19, dans lequel le premier élément de capteur à effet Hall et le deuxième élément de capteur à effet Hall constituent un capteur d'angle ou un capteur de position.

**21.** Aménagement de capteur (300), aux caractéristiques suivantes:

un capteur à effet Hall (310) destiné à détecter une composante d'un champ magnétique de mesure et à sortir un signal de capteur S basé sur la composante détectée du champ magnétique de mesure, et
un moyen de traitement (320) qui est conçu pour réaliser le procédé de compensation de décalage d'un capteur à effet Hall (310) selon l'une des revendications précédentes.

**22.** Aménagement de capteur (300) selon la revendication 21, dans lequel le capteur à effet Hall (310) présente un élément de capteur à effet Hall horizontal ou vertical.

23. Aménagement de capteur (300) selon la revendication 21 ou 22, dans lequel le capteur à effet Hall (310) présente au moins un premier élément de capteur à effet Hall (312) destiné à fournir un premier signal de capteur à effet Hall (S-1) et un deuxième élément de capteur à effet Hall (314) destiné à fournir un deuxième signal de capteur à effet Hall (S-2),

dans lequel le signal de capteur S est basé sur une combinaison du premier et du deuxième signal de capteur à effet Hall (S-1, S-2),
ou
dans lequel le signal de capteur S est basé sur une combinaison d'un premier signal de capteur préparé et d'un deuxième signal de capteur préparé qui sont dérivés du premier et du deuxième signal de capteur à effet Hall.

24. Aménagement de capteur (300) selon la revendication 21 ou 22, dans lequel le capteur à effet Hall (310) présente au moins un premier élément de capteur à effet Hall (312) destiné à fournir un premier signal de capteur à effet Hall (S-1) et un deuxième élément de capteur à effet Hall (314) destiné à fournir un deuxième signal de capteur à effet Hall (S-2),
dans lequel le procédé de compensation de décalage est réalisé avec le premier signal de capteur à effet Hall et le deuxième signal de capteur à effet Hall.

25. Aménagement de capteur (300) selon la revendication 23 ou 24, dans lequel le premier élément de capteur à effet Hall (312) et le deuxième élément de capteur à effet Hall (314) constituent un capteur d'angle ou un capteur de position.

100

Durchführen einer ersten Offsetkompensation an dem Sensorsignal $S_0$ zum Bereitstellen eines vorkompensierten Sensorsignals S, wobei bei der ersten Offsetkompensation ein in Bezug auf ein Versorgungssignal $S_{DD}$ linearer Anteil des Offsets in dem Sensorsignal beseitigt oder zumindest reduziert wird ⎯110

Ermitteln einer Vielzahl N, mit N ≥ 3, von Sensorsignalwerten $S_N$ bei unterschiedlichen Offset-Messvorgängen und mit unterschiedlichen Versorgungssignalwerten $S_{DDN}$ innerhalb eines Zeitintervalls $\Delta t1$, wobei die Offset-Messvorgänge zeitlich so aufeinander folgend ausgeführt werden, dass während des Zeitintervalls $\Delta t1$ das auf das Hall-Sensor einwirkende Messmagnetfeld innerhalb eines Toleranzbereiches konstant ist ⎯120

Bestimmen einer Fitting-Funktion $F(S_{DD})$ für das vorkompensierte Sensorsignal über dem Versorgungssignal $S_{DD}$ basierend auf den ermittelten N Sensorsignalwerten $S_N$, mit

F($S_{DD}$) = Konstanter Anteil + Linearer Anteil + Nicht-linearer Anteil

wobei der nichtlineare Anteil der Fitting-Funktion auf einem Rest-Offsetanteil R in dem vorkompensierten Sensorsignal S basiert, und

(1)  wobei der lineare Anteil der Fitting-Funktion auf dem konstant anliegenden Messmagnetfeld basiert, wenn das vorkompensierten Sensorsignal proportional zu einer erfassten Hall-Spannung des Hall-Sensors ist; und

(2)  wobei der konstante Anteil der Fitting-Funktion auf dem konstant anliegenden Messmagnetfeld basiert, wenn das vorkompensierten Sensorsignal proportional zu dem einwirkenden Messmagnetfeld ist, das basierend auf der erfassten Hall-Spannung und der Empfindlichkeit des Hall-Sensors ermittelt wird ⎯130

Berechnen eines Offset-reduzierten Sensorsignalwerts $S_0$ basierend auf dem Anteil der ermittelten Fitting-Funktion, der auf dem konstant anliegenden Messmagnetfeld basiert ⎯140

Erfassen eines Sensorsignalwerts $S_N$ bei einem Versorgungssignalwert $S_{DDN}$ ⎯150

Ermitteln des Rest-Offsetanteils R des vorkompensierten Sensorsignals S bei dem Versorgungssignalwert $S_{DDN}$ als Differenz zwischen dem Sensorsignalwert $S_N$ und dem Offset-reduzierten Sensorsignalwert $S_0$ ⎯160

Durchführen einer Offsetkompensation an dem Sensorsignal S basierend auf dem ermittelten Offsetanteil R bei dem Versorgungssignalwert $S_{DDN}$ ⎯170

# Fig. 1

200

Ermitteln eines ersten Sensorsignalwerts S1 des Sensorsignals S bei einem ersten Offsetmessvorgang basierend auf einem ersten Versorgungssignalwert $S_{DD1}$ und eines zweiten Sensorsignalwerts S2 des Sensorsignals bei einem zweiten Offsetmessvorgang basierend auf einem zweiten Versorgungssignalwert $S_{DD2}$,

wobei der erste Versorgungssignalwert $S_{DD1}$ so gewählt ist, dass ein Rest-Offsetanteil R1 in dem ersten Sensorsignalwert S1 weniger als 50% des ersten Sensorsignalwerts S1 beträgt, und

wobei der erste und der zweite Offset-Messvorgang zeitlich so aufeinander folgend ausgeführt werden, dass bei dem ersten und zweiten Offsetmessvorgang das auf den Hall-Sensor einwirkende Messmagnetfeld innerhalb eines Toleranzbereiches konstant ist, und

⌒210

Ermitteln eines Offsetanteils R2 in dem Sensorsignal S für den zweiten Versorgungssignalwert $S_{DD2}$ als Differenz zwischen dem zweiten Sensorsignalwert $S_{DD2}$ und dem ersten Sensorsignalwert $S_{DD1}$

⌒220

Durchführen einer Offsetkompensation an dem Sensorsignal S basierend auf dem ermittelten Offsetanteil R bei dem zweiten Versorgungssignalwert $S_{DD2}$.

⌒230

## Fig. 2

SC-Offset [mV] über Versorgungsspannung

—×——×— Messwerte ohne externes Magnetfeld

Fig. 3

Empfindlichkeit über Versorgungsspannung

—×——×— gemessene Empfindlichkeit

Fig. 4

Sensorspannung [mV] über Versorgungsspannung

× × Messwerte bei 7,66mT externem Magnetfeld

——— gefittete typische Funktion

## Fig. 5

Sensorspannung [mV] über Versorgungsspannung

—×—×—×— konstanter Anteil der gefitteten typischen Funktion

—☐—☐—☐— linearer Anteil der gefitteten typischen Funktion

—△—△—△— exponentieller Anteil der gefitteten typischen Funktion

## Fig. 6

Fig. 7

Sensorssignal [mT] über Versorgungsspannung

Differenz (1) - (3) = tatsächlicher Offset-Anteil

Differenz (1) - (2) = kompensierbarer Offset-Anteil

Differenz (2) - (3) = verbleibender Rest-Offset $\approx$ 0

## Fig. 8

310

320

S-1
(optional)

| 312
(optional) |

S

| 314
(optional) |

S-2
(optional)

Sensoranordnung 300

Fig. 9

**IN DER BESCHREIBUNG AUFGEFÜHRTE DOKUMENTE**

**In der Beschreibung aufgeführte Patentdokumente**

- US 2014266176 A1
- US 20140225597 A1
- DE 102011102483 A1